# EUROPÄISCHE PATENTSCHRIFT

(11) **EP 3 680 100 B1**
(45) Veröffentlichungstag und Bekanntmachung des Hinweises auf die Patenterteilung: **30.11.2022**
(21) Anmeldenummer: 19217042.1
(22) Anmeldetag: 17.12.2019
(51) Int. Cl.: B32B 7/12, B05D 3/14, B32B 15/06, B32B 15/08, B32B 25/08, B32B 27/08, C23C 14/14, C23C 16/02, C23C 16/32, C23C 16/40

(54) **VERBUNDMATERIAL MIT HAFTVERMITTLERSCHICHT AUF BASIS VON SI, C UND O**
COMPOSITE MATERIAL WITH ADHESIVE LAYER BASED ON SI, C AND O
MATÉRIAU COMPOSITE POURVU DE COUCHE DE PROMOTEUR D'ADHÉRENCE À BASE DE SI, C ET O

(30) Priorität: 11.01.2019 EP 19151316
(43) Veröffentlichungstag der Anmeldung: 15.07.2020
(73) Patentinhaber: Carl Freudenberg KG, 69469 Weinheim (DE)
(72) Erfinder: von Fragstein, Friederike, 69120 Heidelberg (DE); Marksteiner, Albin, 6336 Langkampfen (AT); Christopher, Roman, 83098 Brannenburg (DE); Rutz, Stephan, 69469 Weinheim (DE); Hallstein, Katharina, 64658 Fürth/Kröckelbach (DE); Feller, Kai, 67295 Bolanden (DE); Fetsch, Yvonne, 68623 Hüttenfeld / Lampertheim (DE); Adler, Matthias, 64646 Heppenheim (DE)

(56) Entgegenhaltungen:
- EP-A1- 2 135 734
- WO-A1-03/005429
- WO-A1-2010/089333
- WO-A2-01/38596
- WO-A2-01/61069
- DE-A1- 19 856 227
- DATABASE WPI Week 201879 Thomson Scientific, London, GB; AN 2018-898665 XP002790554, -& JP 2018 177845 A (DAINIPPON PRINTING CO LTD) 15. November 2018 (2018-11-15)

## Beschreibung

Die Erfindung betrifft ein Verbundmaterial, das das Substrat und eine Polymerschicht aufweist, die durch eine Haftvermittlerschicht miteinander verbunden sind. Die Erfindung betrifft auch Verfahren zur Herstellung der Verbundmaterialien, Dichtungsartikel und Verwendungen.

### Stand der Technik

Verbundmaterialien sind Werkstoffe aus unterschiedlichen miteinander verbundenen Materialien, deren Werkstoffeigenschaften kombiniert werden. Sie bestehen oft aus Schichten unterschiedlicher, miteinander verbundener Materialien. Verbundmaterialien werden unter anderem eingesetzt, um ein Substrat an der Oberfläche mit anderen Eigenschaften auszustatten. So sind Verbundmaterialien aus Metallen und Polymeren bekannt, die durch die Metallkomponente eine hohe Härte und an einer Polymeroberfläche eine hohe Elastizität aufweisen. In anderen Verbundmaterialien werden verschiedene Kunststoffe mit unterschiedlichen Eigenschaften in vorteilhafter Weise kombiniert.

Bei Verbundmaterialien besteht das grundsätzliche Problem, dass die verschiedenen Materialien dauerhaft und stabil miteinander verbunden werden müssen, wofür im allgemeinen Bindemittel eingesetzt werden. Dies ist insbesondere problematisch, wenn die Komponenten sehr unterschiedliche physikalische und chemische Eigenschaften aufweisen. Dies kann beim Verbinden von Metallen und Elastomeren, aber auch beim Verbinden von verschiedenen Kunststoffen der Fall sein. Die Stabilität von Verbundmaterialien aus solchen unterschiedlichen Komponenten ist oft verbesserungsbedürftig, weil das Bindemittel regelmäßig mit einer der Komponenten eine weniger stabile Bindung eingeht.

Im Allgemeinen werden die Schichten solcher Verbundmaterialien im Stand der Technik stoffschlüssig verbunden, beispielsweise durch Kleben oder Schweißen. Die Oberflächen der Schichten können für eine bessere Anbindung auch aktiviert werden, beispielsweise durch chemische Reaktion mit einem Primer. Um wenig kompatible Materialien zu verbinden, können Haftvermittlerschichten eingesetzt werden. Solche Haftvermittlerschichten werden oft durch Auftragen von nasschemischen Primern oder Bindemitteln erzeugt, beispielsweise aus Lösungen oder Schmelzen. Bei solchen Verfahren wird oft ein zu beschichtendes Werkstück in einem Tauchbad oder Sprühprozess mit Bindemittel versehen und anschließend mit der äußeren Schicht einer zweiten Materialkomponente ausgestattet. So werden Dichtringe üblicherweise hergestellt, indem ein Metallring in einem Tauchbad oder Sprühprozess mit Bindemittel beschichtet wird, entnommen wird, und durch Spritzguss mit einer elastomeren Materialkomponente ausgestattet wird, die den Metallring teilweise oder vollständig einschließt. Bei derartigen Verfahren ist nachteilig, dass nasschemische Verfahren viel Bindemittel verbrauchen, das prozessbedingt teilweise nicht genutzt werden kann, was aus ökologischen und auch wirtschaftlichen Gründen unerwünscht ist.

Verbundmaterialien aus Komponenten mit sehr unterschiedlichen Eigenschaften sind insbesondere im Gebiet der Dichtungstechnik von Bedeutung. Dabei werden beispielsweise sehr harte, stabile Komponenten mit elastischen Materialien kombiniert, die unter anderem formschlüssige, dichtende Verbindung ermöglichen. Verbundmaterialien aus harten Grundstoffen und Elastomeren werden in der Dichtungstechnik auch eingesetzt, um die Grundstoffe mit weiteren Eigenschaften auszustatten, wie einer hohen Stabilität gegen Abrieb, guten Benetzbarkeit mit Dichtstoffen oder guten tribologischen Eigenschaften.

Im Stand der Technik werden zur Herstellung von Verbundmaterialien auch plasmagestützte Methoden eingesetzt. Dabei kann auf einem Substrat durch plasmagestützte chemische Gasphasenabscheidung (PE-CVD) eine Haftvermittlerschicht aufgetragen werden, die anschließend mit einer weiteren Schicht verbunden wird. Die Stabilität solcher Verbundmaterialien ist jedoch oft noch verbesserungsbedürftig.

So beschreibt die WO 01/61069 A2 Verfahren zur Herstellung von Verbundmaterialien aus Kunststoff und Metall, bei denen auf ein Metallsubstrat durch PE-CVD eine kohlenstoffreiche Schicht aufgetragen wird. Als Vorläuferverbindung im Plasma wird dabei Acetylen eingesetzt. Es ist bekannt, dass durch Abscheidung von Acetylen im Plasma hochvernetzte amorphe Kohlenstoffschichten erhalten werden, die auch als "Diamond-like Carbon" (DLC) bezeichnet werden. Dabei wird auch vorgeschlagen, solche mit Kohlenstoff im Plasma beschichtete Metallsubstrate mit Kunststoffen zu verbinden. Haftvermittlerschichten aus DLC, die im Wesentlichen aus Kohlenstoff, Wasserstoff und gegebenenfalls noch geringen Anteilen an Sauerstoff bestehen, weisen jedoch verschiedene Nachteile auf. So ist die Anbindung an viele Substrate, insbesondere metallische Substrate, und dabei vor allem an Edelstahl, oft unzureichend. Auch ist nachteilig, dass DLC-Schichten eine relativ hohe Eigenspannung aufweisen, was die Schichtstabilität und Haftung reduzieren kann. Dies kann dazu führen, dass solche DLC-Schichten von dem Substrat abplatzen. Die Stabilität solcher Verbundmaterialien mit DLC-Schichten ist daher noch verbesserungsbedürftig.

Weitere Verbundmaterialien mit im Plasma erzeugten Haftvermittlerschichten werden in der WO 01/38596 A2 beschrieben. Dabei wird vorgeschlagen, metallische Substrate mit einer Haftvermittlerschicht auszustatten, die aus einem oxidierenden Gas und Organosiliciumverbindungen wie Hexamethyldisiloxan (HMDSO), die nicht Tetramethylsilan sind, als Vorläuferverbindungen zu erzeugen. Das mit der Haftvermittlerschicht ausgestattete Substrat wird anschließend mit einem organischen Überzug ausgestattet, der bevorzugt ein Lack ist. Insbesondere wird ein Coil-Coating-Lack eingesetzt und eingebrannt. Bei dem Verfahren ist nachteilig, dass solche aus HMDSO hergestellten Beschichtungen einen hohen Anteil von Si und O aufweisen, was zu einer SiO₂-ähnlichen Struktur mit hoher Härte führt. Die Anbindung solcher relativ harten Substrate an weitere Materialien, wie Elastomere, ist oft wenig stabil und verbesserungsbedürftig.

Die DE 198 56 227 A1 betrifft Verfahren zur Aktivierung von Oberflächen von Fluorpolymeren mit niedriger Oberflächenenergie, wie PTFE (Teflon). Dadurch soll die reaktionsträge Oberfläche mit funktionellen Gruppen ausgestattet werden. Die im Plasma aktivierten Fluorpolymere können zur Herstellung von Materialverbunden eingesetzt werden, die beispielsweise durch Metallisieren oder Verkleben erzeugt werden. Als Prozessgas für die Plasmaaktivierung wird eine Vielzahl von Vorläuferverbindungen vorgeschlagen, um verschiedene funktionelle Gruppen an der Oberfläche zu erzeugen. In den Ausführungsbeispielen wird das PTFE-Substrat im Plasma mit Ammoniak oder mit HMDSO als Prozessgas modifiziert. Das so aktivierte Zwischenprodukt wird anschließend mit einem Klebstoff an eine Metallfolie geklebt. Nachteilig ist dabei, dass die Stabilität von solchen verklebten Verbundmaterialien aus unterschiedlichen Materialien oft unzureichend ist. Allgemein sind die Verfahren spezifisch für inertes PTFE geeignet und das Produkt ist vergleichsweise unreaktiv. Daher sind die beschriebenen Verfahren und Verbundmaterialien noch verbesserungsbedürftig.

Die US 2012/0315472 A1 offenbart Verbundmaterialien aus einem Kunststoff- oder Metallsubstrat und einer im Plasma mit Acetylen erzeugten Haftvermittlerschicht. Dabei wird eine harte DLC-Schicht erhalten, die mit einer Polymerverbindung beschichtet und durch Vulkanisieren ausgehärtet wird. Dabei ist nachteilig, dass die Stabilität der Verbundmaterialien wegen der Härte der DLC-Schicht verbesserungsbedürftig ist.

Die EP 0 317 134 A2 beschreibt Verfahren, bei denen ein Substrat mit einer abriebresistenten Beschichtung ausgestattet wird. Die Beschichtung wird im Plasma in Gegenwart von Silanen, Alkenen und einer Sauerstoffquelle als Vorläuferverbindungen abgeschieden. Die beschichteten Materialien sollen sich wegen ihrer hohen Stabilität für verschiedene Anwendungen eignen, beispielsweise als Fenster oder Windschutz. Es wird nicht offenbart, die beschichteten Materialien weiter zu verarbeiten.

Abriebfeste Beschichtungen werden auch in der EP 0 590 467 A1 offenbart. Dabei werden durch PE-CVD Beschichtungen auf Basis von Organosilanen oder Organosiloxanen erzeugt, wobei ungesättigte Kohlenwasserstoffe hinzugefügt werden können. Die beschichteten Produkte sollen kratzfest und als Acrylgläser geeignet sein. Es wird nicht offenbart, die beschichteten Kunststoffe weiterzuverarbeiten.

Die JP 2018 177845 A betrifft Haftvermittlerschichten für Fluorpolymere, die durch chemische Gasphasenabscheidung aus siliziumorganischen Verbindungen, wie HMDSO, erzeugt werden. Es wird nicht offenbart, Gemische die siliziumorganischen Verbindungen mit anderen Vorläuferverbindungen zu mischen.

Die WO 2010/089333 A1 betrifft ein Verfahren zum Beschichten der Oberfläche eines Kunststoffsubstrates mittels Plasmapolymerisation, wobei als Vorläuferverbindungen siliciumorganische Verbindungen eingesetzt werden.

Die EP 2 135 734 A1 betrifft einen geformten Kunststoffgegenstand, der ein Kunststoffsubstrat und einen aufgedampften Film aufweist, der durch ein Plasma-CVD-Verfahren auf der Oberfläche des Kunststoffsubstrats gebildet ist.

Die WO 03/005429 A1 betrifft Beschichtungen, die eine niedrige Dielektrizitätskonstante aufweisen. Die Beschichtungen werden als Filme auf elektronische Geräte aufgetragen.

Die Herstellung erfolgt durch chemische Gasphasenabscheidung aus Gemischen von ungesättigten Kohlenwasserstoffen und siliziumorganischen Verbindungen. Als Substrate werden metallische Oberflächen eingesetzt, wie Platinoberflächen. Das Dokument betrifft nicht das Verbinden von Materialien durch Haftvermittlerschichten.

Im Stand der Technik besteht ein kontinuierlicher Bedarf nach verbesserten Verbundmaterialien, bei denen Schichten aus unterschiedlichen Materialien stabil miteinander verbunden sind.

### Aufgabe der Erfindung

Der Erfindung liegt die Aufgabe zugrunde, Verbundmaterialien, Verfahren und Verwendungen bereitzustellen, welche die oben beschriebenen Probleme lösen. Insbesondere liegt der Erfindung die Aufgabe zugrunde, Verfahren und Verbundmaterialien bereitzustellen, die eine stabile Verbindung unterschiedlicher Materialien ermöglichen.

Dabei liegt der Erfindung insbesondere das Problem zugrunde, Metalle mit Polymeren oder verschiedene Polymere stabil miteinander zu verbinden. Insbesondere besteht das Problem, starre Materialien, wie Metalle oder starre Kunststoffe, mit weichen Materialien, wie Elastomeren, stabil zu verbinden.

Die Verbundmaterialien sollen dabei bevorzugt aus üblichen Komponenten und mit relativ einfachen Verfahren in wenigen Schritten erhältlich sein. Die Verfahren sollen möglichst wenig Material verbrauchen und dadurch möglichst wirtschaftlich und umweltschonend sein.

Der Erfindung liegt weiterhin die Aufgabe zugrunde, Haftvermittlerschichten bereitzustellen, die auf einer Vielzahl von verschiedenen, insbesondere starren, Substraten gut haften und dabei insbesondere eine stabile Verbindung mit einer Vielzahl weiterer, unterschiedlicher Materialien ermöglichen.

### Offenbarung der Erfindung

Überraschenderweise wird die der Erfindung zugrunde liegende Aufgabe gelöst durch Verbundmaterialien und Verfahren gemäß den Patentansprüchen.

Gegenstand der Erfindung ist ein Verbundmaterial, das ein Substrat und eine Polymerschicht aufweist, die durch eine Haftvermittlerschicht miteinander verbunden sind, wobei die Haftvermittlerschicht durch plasmagestützte chemische Gasphasenabscheidung (PE-CVD) erhältlich ist, bei der zumindest teilweise ein Gemisch von Vorläuferverbindungen eingesetzt wird, das einen ungesättigten Kohlenwasserstoff und eine siliciumorganische Verbindung enthält.

Der Begriff "Substrat" bezeichnet einen Formkörper, der mit der Polymerschicht beschichtet ist. Das Substrat ist durch die Haftvermittlerschicht mit der Polymerschicht verbunden. Die Haftvermittlerschicht wird im Plasma auf dem Substrat erzeugt. Somit ist auf der Oberfläche des Substrats, oder einem Teil davon, die Haftvermittlerschicht aufgebracht, auf welche die Polymerschicht aufgebracht ist. Das Verbundmaterial weist somit drei übereinander liegende Komponenten (Schichten) auf, die flächig miteinander verbunden sind. Das Substrat ist an der Oberfläche mit der Polymerschicht beschichtet. Zur Verdeutlichung der flächigen Verbindung an der Oberfläche des Substrats kann das Verbundmaterial auch so beschrieben werden, dass das Substrat als "Substratschicht" bezeichnet wird. Die "Substratschicht" ist dabei also das Substrat selbst, und nicht ein Teil des Substrats oder eine unterschiedliche oder weitere Komponente.

Das Verbundmaterial weist somit mindestens drei Komponenten (Schichten) auf. Die Komponenten (Schichten) sind flächig und stabil miteinander verbunden. Dabei wird das Substrat, also der Bereich an der Oberfläche des Substrats bzw. die Substratschicht, über die Haftvermittlerschicht mit der Polymerschicht verbunden. Dies bedeutet, dass keine weiteren Schichten zwischen der Haftvermittlerschicht und dem Substrat, also der Oberfläche des Substrats bzw. der Substratschicht, sowie zwischen der Haftvermittlerschicht und der Polymerschicht vorhanden sind.

Das Verbundmaterial kann auf der jeweils von der Haftvermittlerschicht abgewandten Seite des Substrats oder der Polymerschicht weitere Schichten aufweisen. Die drei Komponenten bzw. Schichten des Verbundmaterials sind stoffschlüssig miteinander verbunden. Dabei ist die Haftvermittlerschicht bevorzugt kovalent mit der Polymerschicht verbunden, wobei die Bindung insbesondere durch eine Vernetzungsreaktion erfolgte. Bevorzugt ist auch das Substrat kovalent mit der Haftvermittlerschicht verbunden.

Überraschenderweise wurde gefunden, dass aus ungesättigten Kohlenwasserstoffen in Verbindung mit siliciumorganischen Verbindungen im PE-CVD Verfahren eine Haftvermittlerschicht erhalten werden kann, die mit einer Vielzahl von Substraten eine stabile und dauerhafte Bindung eingeht. Diese im Plasma erzeugte Beschichtung dient erfindungsgemäß als Haftvermittlerschicht.

Dabei kann das Substrat grundsätzlich aus jedem Material, das im Plasma mit einer Beschichtung auf Basis von Si, C, O und H ausgestattet werden kann, bestehen. Beispielsweise kann das Substrat ein Metallsubstrat, ein Polymersubstrat (Kunststoffsubstrat) oder ein Keramiksubstrat sein. Das Substrat kann auch selbst ein Verbundmaterial sein. Beispielsweise kann das Substrat ein Polymersubstrat sein, das Füllstoffe, Fasern oder andere Komponenten enthält, oder ein komplexes Bauteil aus mehreren Komponenten, das eine geeignete zu beschichtende Oberfläche aufweist. Bevorzugt ist das Substrat ein Metallsubstrat oder ein Polymersubstrat. Das Substrat kann vollständig oder lokal beschichtet werden, beispielsweise indem nicht zu beschichtende Bereiche der Oberfläche beim Aufbringen der Haftvermittlerschicht und/oder der Polymerschicht abgedeckt werden.

In einer besonders bevorzugten Ausführungsform ist das Substrat ein Metallsubstrat. Im Plasma können Metalle besonders effizient mit Beschichtungen auf Basis von Si, C, O und H ausgestattet werden. Dabei können übliche Substrate für Verbundmaterialien eingesetzt werden. Das Metall ist bevorzugt ausgewählt aus Stahl, insbesondere Edelstahl, Eisen, Aluminium, Silicium oder Messing.

In einer weiteren bevorzugten Ausführungsform ist das Substrat ein Polymersubstrat (Kunststoffsubstrat). Dabei bildet das Polymer eine Matrix aus. Bevorzugt ist das Polymer ein Thermoplast oder Duroplast. Geeignete Polymere sind beispielsweise Thermoplaste wie Polyolefine (Polypropylen, Polyethylen), Polyamide, Polyester (wie Polybutylentherephthalat), Polyphenylensulfide oder Fluorpolymere wie Polytetrafluorethylen, Polyvinylidenfluorid, Perfluoralkoxy-Polymere oder Gemische solcher Polymere. Dabei können auch Faser- oder Partikel-verstärke Werkstoffe eingesetzt werden, die auf diesen Polymeren basieren. Allgemein kann die Polymermatrix übliche Additive enthalten, insbesondere Füllstoffe. Solche Polymere weisen ausreichende Festigkeiten auf, um im Plasma mit Beschichtungen auf Basis von Si, C und O ausgestattet zu werden.

Das Substrat kann auch ein anorganisches Substrat sein, insbesondere aus Metall, Keramik, Glas oder Oxiden von Metallen oder Halbmetallen, wie Silica. Besonders bevorzugt ist dabei ein Substrat aus Metall.

Die Haftvermittlerschicht ist durch plasmagestützte chemische Gasphasenabscheidung (PE-CVD) erhältlich. Dabei wird die Haftvermittlerschicht durch PE-CVD auf das Substrat aufgetragen. Die Verbindung mit der Polymerschicht erfolgt erst nach Abschluss des Plasmaverfahrens. Die Haftvermittlerschicht enthält die Elemente Si, C, O und H. Da die Struktur dabei durch Si, C und O geprägt wird, während die H Atome endständig an die anderen Elemente angehängt sind, wird die Haftvermittlerschicht im Rahmen dieser Anmeldung auch als Haftvermittlerschicht auf Basis von Si, C und O bezeichnet. Die Haftvermittlerschicht kann auch weitere Elemente enthalten, wie N oder Halogen, wie Cl oder F.

Verfahren zur Erzeugung von Beschichtungen auf Substraten mittels PE-CVD sind im Stand der Technik bekannt und beschrieben. Lediglich beispielsweise wird auf die einleitend erörterten Druckschriften verwiesen. Generell werden Beschichtungen im Plasma aus Si, C, O und H erhalten, wenn dem Plasma gas- oder dampfförmige Vorläuferverbindungen zugeführt werden, die Si-, C-, O- und H-Atome aufweisen. Die Vorläuferverbindungen werden im Plasma aktiviert und bilden auf der Substratoberfläche vernetzte Schichten aus. Mit Vorläuferverbindung werden Verbindungen bezeichnet, deren Bestandteile zum Schichtwachstum beitragen. Keine Vorläuferverbindungen sind daher Trägergase oder Inertgase, die zusätzlich in dem Gemisch enthalten sein können. Plasma-Beschichtungen unterscheiden sich signifikant von Beschichtungen mit vergleichbaren Zusammensetzungen, die beispielsweise durch herkömmliche Polymerisationsverfahren und Vernetzungsverfahren erhalten werden. Plasma-Beschichtungen bilden charakteristische, nicht stöchiometrische Strukturen aus, die nicht ohne weiteres durch eine chemische Formel beschreibbar sind.

Die Haftvermittlerschicht wird durch einen PE-CVD-Prozess erhalten, wobei mindestens teilweise ein Gemisch von Vorläuferverbindungen eingesetzt wird, das mindestens einen ungesättigten Kohlenwasserstoff und mindestens eine siliciumorganische Verbindung enthält. Somit können in dem Gemisch auch zwei, drei oder mehr verschiedene ungesättigte Kohlenwasserstoffe und/oder zwei, drei oder mehr siliciumorganische Verbindungen enthalten sein. Bevorzugt enthält das Gemisch keine weiteren Vorläuferverbindungen und/oder bei der PE-CVD werden keine weiteren Vorläuferverbindungen eingesetzt.

Überraschenderweise wurde gefunden, dass mit einem solchen Gemisch von Vorläuferverbindungen eine besonders stabile haftende Verbindung erreicht werden kann. Insbesondere ist die Stabilität der Verbundmaterialien signifikant höher als die von vergleichbaren Verbundmaterialien, bei denen die Haftvermittlerschicht nur aus ungesättigten Kohlenwasserstoffen oder nur aus einer siliciumorganischen Verbindung erzeugt wird.

Erfindungsgemäß können Haftvermittlerschichten erzeugt werden, die vorteilhafte Eigenschaften von DLC-Beschichtungen und Si-haltigen Beschichtungen vereinen. DLC (Diamond-like Carbon) ist ein beispielsweise durch PE-CVD erhältliches Material auf Basis von Kohlenstoff, das eine hohe Härte und Stabilität aufweist. In einer bevorzugten Ausführungsform bildet die Haftvermittlerschicht eine Struktur aus, bei der die Kohlenstoffatome im Wesentlichen wie in einer DLC-Schicht ohne Silicium angeordnet sind. Die Schicht ähnelt daher näherungsweise einer DLC-Schicht, die mit Silicium dotiert ist. Allgemein ist dabei aber zu beachten, dass eine genaue Struktur von Schichten, die durch PE-CVD erzeugt werden, nur schwer oder näherungsweise ermittelbar ist. Da im Plasma eine Vielzahl von reaktiven Radikalen, Ionen, Neutralteilchen und Verbindungen auf eine Vielzahl von Weisen reagieren und abgeschieden werden können, weisen Plasma-Schichten auf molekularer Ebene keine genau definierten Strukturen auf. So können die Beschichtungen beispielsweise Kohlenstoffdoppelbindungen, Kohlenstoffdreifachbindungen oder radikalische Gruppen aufweisen. Daher ist es in dem technischen Gebiet üblich und auch sinnvoll, Plasma-Beschichtungen durch die Vorläuferverbindungen zu charakterisieren.

Erfindungsgemäß ist es bevorzugt, dass in der Haftvermittlerschicht ein wesentlicher Teil der Si-Atome die DLC-Struktur dotiert, was bedeutet, dass C-Atome in der DLC-Struktur durch Si-Atome ersetzt sind. Bevorzugt liegen mindestens 20%, mindestens 40% oder besonders bevorzugt mehr als 60% der Si-Atome als Dotierung in der DLC-Struktur vor. Die Hybridisierungszustände der C-Atome und die Positionen der Si-Atome lassen sich spektroskopisch bestimmen. In einer Ausführungsform ist ein wesentlicher Anteil der Kohlenstoffatome in der Haftvermittlerschicht sp² hybridisiert. So können mindestens 20%, bevorzugt mindestens 40% oder insbesondere mindestens 60% der Kohlenstoffatome sp² hybridisiert sein. Dabei kann der Anteil an sp² hybridisiertem Kohlenstoff zwischen 20% und 90% sein, insbesondere zwischen 40% und 80%. Der Anteil an sp² hybridisiertem Kohlenstoff kann durch Raman-Spektroskopie ermittelt werden.

Im Rahmen dieser Anmeldung bedeutet "siliciumorganische Verbindung", dass die Verbindung Si, C, H und gegebenenfalls O enthält. Dabei kann die Verbindung weitere Elemente enthalten, wie N oder Halogene. Die siliciumorganische Verbindung ist bevorzugt eine niedermolekulare, also nicht polymere Verbindung. Bevorzugt ist die siliciumorganische Verbindung ein Siloxan, ein Silan oder ein Silikat.

Siloxane sind chemische Verbindungen der allgemeinen Formel R₃Si-[O-SiR₂]ₙ-O-SiR₃, wobei die Reste R Wasserstoffatome oder Alkylgruppen sein können. Im Gegensatz zu Silanen sind die Siliciumatome nicht direkt, sondern durch ein Sauerstoffatom mit ihrem benachbarten Siliciumatom verknüpft. Sie weisen somit Si-O-Si Gruppen auf. Siloxane mit R = CH₃ heißen Polydimethylsiloxane.

Bevorzugt weisen die Siloxane 2 bis 6 Siliciumatome auf. Besonders bevorzugt ist das Siloxan ausgewählt aus Hexamethyldisiloxan (HMDSO), Disiloxan oder Octamethyltrisiloxan. Es wurde gefunden, dass sich solche Vorläuferverbindungen besonders gut zur Herstellung von Haftvermittlerschichten mit ungesättigten Kohlenwasserstoffen als weiteren Vorläuferverbindungen eignen.

In einer bevorzugten Ausführungsform ist das Siloxan HMDSO. HMDSO wird in seinen physikalischen und chemischen Eigenschaften häufig zur Herstellung von siliciumhaltigen Beschichtungen im Plasma eingesetzt. Hinzu kommt, dass HMDSO gut mit ungesättigten Kohlenwasserstoffen im Plasma reagiert, insbesondere mit Ethylen oder Acetylen.

Die Bezeichnung Silane steht nach den IUPAC-Regeln für eine Stoffgruppe chemischer Verbindungen, die aus einem Silicium-Grundgerüst und Wasserstoff bestehen. Silane können einen verzweigten (iso- und neo-Silane) oder unverzweigten (n-Silane) Aufbau aufweisen. Die allgemeine Summenformel der nicht cyclischen (offenkettigen) Silane ist SiₙH₂ₙ₊₂. Ringförmige Silicium-Wasserstoff-Verbindungen werden als Cyclosilane bezeichnet (allgemeine Summenformel: SiₙH₂ₙ).

Bevorzugt weist das Silan als Vorläuferverbindung 1 bis 6 Siliciumatome, besonders bevorzugt 1 bis 3 Siliciumatome auf. Insbesondere ist das Silan ausgewählt aus Tetramethylsilan (TMS), Disilan (Si₂H₆) oder Trisilan (Si₃H₈).

Besonders bevorzugt ist das Silan Tetramethylsilan (TMS). Verfahren zur Herstellung von Plasma-Beschichtungen mit TMS sind im Stand der Technik bekannt. TMS eignet sich wegen der physikalischen und chemischen Eigenschaften besonders gut zur Erzeugung von Plasma-Beschichtungen. Es eignet sich auch in Gemischen mit ungesättigten Kohlenwasserstoffen zur Erzeugung von Haftvermittlerschichten.

In einer weiteren Ausführungsform ist die siliciumorganische Verbindung ein Silikat, insbesondere Tetraethylorthosilicat (TEOS, auch als Tetraethoxysilan bezeichnet).

Ungesättigte Kohlenwasserstoffe sind Verbindungen aus C und H, die mindestens eine Doppel- oder Dreifachbindung aufweisen. Erfindungsgemäß werden dabei insbesondere aliphatische Kohlenwasserstoffe eingesetzt. Besonders bevorzugt sind dabei Alkene oder Alkine. Bevorzugt werden dabei Alkene oder Alkine eingesetzt, die 2 bis 8 Kohlenstoffatome, insbesondere 2 bis 6 Kohlenstoffatome aufweisen. Beispielsweise kann der ungesättigte Kohlenwasserstoff ausgewählt sein aus Ethylen (Ethen), Propen, Buten, Penten, Hexen, Cyclohexen, Propylen oder Butylen, oder aus Acetylen (Ethin), Propin oder Butin.

In einer bevorzugten Ausführungsform ist der ungesättigte Kohlenwasserstoff Ethylen oder Acetylen. Ethylen und Acetylen eignen sich wegen ihren physikalischen und chemischen Eigenschaften besonders zur Herstellung von Plasma-Beschichtungen. Besonders bevorzugt wird Acetylen eingesetzt. Wenn Acetylen mit einer siliciumhaltigen Vorläuferverbindung zur Herstellung von Plasma-Haftvermittlerschichten eingesetzt wird, kann eine starke Bindung erzeugt werden. Ohne an eine Theorie gebunden zu sein, könnte dies daran liegen, dass eine solche Haftvermittlerschicht an der Oberfläche einen relativ hohen Anteil ungesättigter Gruppen aufweist, die mit der Polymerschicht vernetzt werden können. Zudem enthalten die Oberflächen solcher Plasma-Beschichtungen oft polare funktionelle Gruppen, wie Carbonyl- oder Carboxygruppen, die durch nachgelagerte Reaktionen entstehen, beispielsweise durch Reaktion von Radikalen in der Plasma-Beschichtung mit Luftsauerstoff, und ebenfalls für weitere Reaktionen bereitstehen. Radikale in der Plasma-Beschichtung könnten ebenfalls mit der Polymerschicht reagieren.

Die Haftvermittlerschicht kann eine im Wesentlichen homogene Struktur oder eine heterogene Struktur und/oder Zusammensetzung aufweisen. Die Zusammensetzung der Schicht kann insbesondere über die Dicke der Schicht variieren. Eine homogene Struktur kann erhalten werden, wenn bei der PE-CVD die Verfahrensbedingungen, und dabei auch die Zusammensetzung des Gemischs der Vorläuferverbindungen, konstant gehalten wird. Eine heterogene Struktur kann erhalten werden, wenn bei der Beschichtung im Plasma die Verfahrensbedingungen, und dabei insbesondere die Zusammensetzung des Gemischs der Vorläuferverbindung, verändert wird.

Bei der PE-CVD wird das Gemisch von Vorläuferverbindungen, das einen ungesättigten Kohlenwasserstoff und eine siliciumorganische Verbindung enthält, zumindest teilweise eingesetzt. Bei solchen PE-CVD Prozessen kann die Art und Menge der Vorläuferverbindungen während der Reaktion verändert werden. Dies geschieht üblicherweise über den zugeführten Gasstrom. In diesem Zusammenhang bedeutet "teilweise", dass die PE-CVD so geführt werden kann, dass ein Teil der Haftvermittlerschicht nicht aus einem Gemisch erzeugt wird, dass einen ungesättigten Kohlenwasserstoff und eine siliciumorganische Verbindung enthält. Dies kann vorteilhaft sein, um beispielsweise Gradientenschichten herzustellen.

In einer bevorzugten Ausführungsform wird zur Erzeugung eines Teils der Haftvermittlerschicht ein Gemisch von Vorläuferverbindungen eingesetzt wird, das einen ungesättigten Kohlenwasserstoff und eine siliciumorganische Verbindung enthält, wobei ein anderer Teil der Haftvermittlerschicht nur aus ungesättigten Kohlenwasserstoffen und/oder siliciumorganischer Verbindung hergestellt wird.

In einer bevorzugten Ausführungsform wird die Plasma-Reaktion ausschließlich mit ungesättigten Kohlenwasserstoffen und eine siliciumorganischen Verbindungen als Vorläuferverbindungen durchgeführt.

In einer bevorzugten Ausführungsform ist die Haftvermittlerschicht als Gradientenschicht ausgebildet. Der Gradient kann dabei ein kontinuierlicher Gradient oder ein Stufengradient sein. Zur Erzeugung eines kontinuierlichen Gradienten kann die Zusammensetzung der Vorläuferverbindungen bei dem Plasmaprozess kontinuierlich verändert werden. Zur Herstellung eines Stufengradienten kann die Zusammensetzung der Vorläuferverbindungen schrittweise verändert werden. Eine Gradientenschicht kann auch erzeugt werden, wenn die Konzentration des Gemisches gleich bleibt, aber andere wesentliche Verfahrensparameter, wie die Leistung, verändert werden.

Dabei ist es bevorzugt, einen Gradienten auszubilden, der zu einer verbesserten Haftung an den beiden Seiten der Haftvermittlerschicht führt. Bevorzugt nimmt dabei in der Gradientenschicht der Anteil an Kohlenstoff zur Polymerschicht hin zu und der Anteil an Si zur Polymerschicht hin ab. Dies ist von Vorteil, weil eine Haftvermittlerschicht mit relativ hohem Kohlenstoffanteil oft eine besonders starke Bindung mit der Polymerschicht eingehen kann. Diese Ausführungsform ist besonders bevorzugt, wenn ein anorganisches Substrat eingesetzt wird, beispielsweise ein Metallsubstrat. Metalle können oft relativ starke Verbindungen mit Haftvermittlerschichten mit relativ hohem Si-Anteil eingehen. Es ist besonders bevorzugt, dass auf dem Substrat, das insbesondere ein Metall ist, zuerst ein unterer Teil der Haftvermittlerschicht erzeugt wird, wobei als Vorläuferverbindung nur siliciumorganische Verbindung eingesetzt wird, wonach darüber ein oberer Teil der Haftvermittlerschicht aus dem Gemisch von Vorläuferverbindungen, das einen ungesättigten Kohlenwasserstoff und eine siliciumorganische Verbindung enthält, erzeugt wird.

Besonders bevorzugt ist ein Verfahren, bei dem eine Haftvermittlerschicht mit HMDSO oder TMS und Acetylen oder Ethylen als Vorläuferverbindungen erzeugt wird, wobei der Anteil an HMDSO oder TMS an den Vorläuferverbindungen während dem Prozess abnimmt, und/oder wobei der Anteil an Acetylen oder Ethylen an den Vorläuferverbindungen während dem Prozess zunimmt. Bevorzugt ist das Substrat dabei ein anorganisches Substrat, insbesondere ein Metallsubstrat, oder ein nicht fluorhaltiges Polymersubstrat.

In einer bevorzugten Ausführungsform weist die Haftvermittlerschicht eine Dicke von 30 nm bis 10 µm auf. Allgemein ist es bevorzugt, dass die Haftvermittlerschicht eine möglichst niedrige Dicke aufweist, und dabei gleichzeitig eine stabile Verbindung des Substrats mit der Polymerschicht bewirkt.

Bei solchen Reaktionen im Plasma werden die Mengen und Verhältnisse der Vorläuferverbindungen üblicherweise über den Volumenstrom eingestellt. In einer bevorzugten Ausführungsform wird die Plasma-Reaktion so durchgeführt, dass das Verhältnis der Volumenströme der ungesättigten Kohlenwasserstoffe und siliciumorganischen Verbindungen 20:1 bis 1:20, bevorzugt von 5:1 bis 1:5, und dabei insbesondere von 2:1 bis 1:2 ist (in Standardkubikzentimeter, sccm). In einer weiteren Ausführungsform enthält das Gemisch von Vorläuferverbindungen ungesättigte Kohlenwasserstoffe und siliciumorganische Verbindungen in einem Gewichtsverhältnis von 5:1 bis 1:5, insbesondere im Verhältnis von 2:1 bis 1:2.

Bevorzugt enthält das Gemisch, das bei dem PE-CVD-Prozess eingesetzt wird, als Vorläuferverbindungen ausschließlich ungesättigte Kohlenwasserstoffe und siliciumorganische Verbindungen. Insbesondere ist bevorzugt, dass das Gemisch aus einem Kohlenwasserstoff, ausgewählt aus Ethylen oder Acetylen, und einer Siliciumverbindung, ausgewählt aus HMDSO oder TMS, besteht. Erfindungsgemäß wurde gefunden, dass eine Haftvermittlerschicht mit starker Bindungswirkung erhalten werden kann, wenn lediglich diese reaktiven Vorläuferverbindungen eingesetzt werden. Auf diese Weise kann die Haftvermittlerschicht auf einfache Weise aus gut verfügbaren und handhabbaren Vorläuferverbindungen erzeugt werden, wobei eine relativ homogene Haftvermittlerschicht erhalten werden kann.

In einer bevorzugten Ausführungsform wird der PE-CVD-Prozess nicht in Gegenwart einer zusätzlichen Sauerstoffquelle, wie O₂, H₂O oder N₂O, durchgeführt. Die EP 0 317 134 A2 schlägt vor, Beschichtung im Plasma mit Silanen, Alkenen und einer zusätzlichen Sauerstoffquelle zu erzeugen, um eine hohe Härte zu erhalten. Erfindungsgemäß wurde gefunden, dass eine hohe Stabilität erreicht werden kann, ohne dass eine zusätzliche Sauerstoffquelle verwendet wird.

Nachfolgend werden bevorzugte Zusammensetzungen der Haftvermittlerschicht beschrieben. In einer bevorzugten Ausführungsform weist mindestens die Oberfläche der Haftvermittlerschicht die jeweilige Zusammensetzung auf. Dabei lässt sich die Zusammensetzung der Haftvermittlerschicht an der Oberfläche, insbesondere bis zu einer Tiefe von 10 nm, auf einfache Weise mittels XPS ermitteln. Die Zusammensetzung an der Oberfläche ist für die Anbindung an die Polymerschicht von besonders hoher Bedeutung. In einer weiteren Ausführungsform weist die Haftvermittlerschicht insgesamt die genannte Zusammensetzung auf.

Die hier und nachfolgend angegebenen Anteile in Atom-% für die Elemente Si, O und C werden bevorzugt mittels XPS ermittelt. Dabei kann der Anteil an H mittels XPS nicht detektiert werden. Der Rest des Gewichts besteht bevorzugt aus H, und gegebenenfalls weiteren Elemente, wie N, Halogen, wie F oder Cl, oder Metallen, wie Fe. Dabei besteht der Rest bevorzugt aus Wasserstoff und gegebenenfalls weiteren Elemente aus dem Substrat. Es ist bekannt, dass sich bei solchen Verfahren im Plasma Atome oder Moleküle aus der Substratoberfläche ablösen können und in die Plasmabeschichtung übergehen. So kann bei Beschichtungen auf Edelstahl oft ein geringer Anteil Fe in der Beschichtung nachgewiesen werden und bei Beschichtungen auf fluorhaltigen Polymeren oft ein Anteil Fluor in der Beschichtung nachgewiesen werden.

Bevorzugt ist der Anteil von Si + C + O an der Oberfläche der Haftvermittlerschicht und/oder der Haftvermittlerschicht insgesamt >90 at.%, insbesondere >95 at.% oder >98 at.%.

Die Oberfläche der Haftvermittlerschicht und/oder die Haftvermittlerschicht insgesamt weisen bevorzugt einen relativ geringen Anteil an Si auf, der insbesondere <25 at.% oder <20 at.% ist. Es ist bevorzugt, dass der Anteil an Si dabei zwischen 3 at% und 25 at%, insbesondere zwischen 4 at% und 20 at%, und besonders bevorzugt zwischen 4 at% und 15 at% ist.

Die Oberfläche der Haftvermittlerschicht und/oder die Haftvermittlerschicht insgesamt weisen bevorzugt einen relativ hohen Anteil an C auf, der insbesondere >50 at.% oder >60 at.% ist. Es ist bevorzugt, dass dabei der Anteil an C zwischen 50 at% und 90 at%, insbesondere zwischen 60 at% und 85 at%, und besonders bevorzugt zwischen 65 at% und 85 at% ist.

Die Oberfläche der Haftvermittlerschicht und/oder die Haftvermittlerschicht insgesamt weisen bevorzugt einen relativ niedrigen Anteil an O auf, der insbesondere <25 at.% oder <20 at.% ist. Es ist bevorzugt, dass dabei der Anteil an O zwischen 5 at% und 25 at%, insbesondere zwischen 10 at% und 20 at% ist.

Bevorzugt bestehen die Oberfläche der Haftvermittlerschicht und/oder die Haftvermittlerschicht insgesamt aus:

| | |
|---|---|
| Si: | 3 at% bis 25 at%, insbesondere 4 at% bis 20 at%, |
| C: | 50 at% bis 90 at%, insbesondere 60 at% bis 85 at%, |
| O: | 5 at% bis 25 at%, insbesondere 10 at% bis 20 at%, |

| | |
|---|---|
| wobei die Summe aus Si + C + O bevorzugt > 90%, insbesondere >95% oder >98% ist, wobei der Rest bevorzugt H, N und weitere Elemente aus dem Substrat sind. | |

Die elementare Zusammensetzung der Haftvermittlerschicht wird an der äußersten Oberfläche der Schicht insbesondere durch Röntgenphotoelektronenspektroskopie (ESCA, XPS) ermittelt werden. Die elementare Zusammensetzung kann auch mit höherer Tiefenauflösung durch Energie-dispersive Röntgenspektroskopie (EDX) gemessen werden. Die Fourier-Transformations-Infrarotspektrometrie (FTIR) kann ergänzend zur Strukturaufklärung eingesetzt werden, und dabei insbesondere zur Identifizierung funktioneller Gruppen. Falls die Zusammensetzung der Haftvermittlerschicht über die Schichtdicke nicht gleichförmig ist, beispielsweise weil die Schicht einen Gradienten aufweist, kann die Zusammensetzung im Inneren der Schicht beispielsweise durch XPS an schrägen Schnitten ermittelt werden.

Die Haftvermittlerschicht ist bevorzugt kovalent mit der Polymerschicht verbunden. Die kovalente Bindung wird bevorzugt erzeugt, nachdem die Polymerschicht, oder eine Polymerverbindung als Vorläufer der Polymerschicht, auf die Haftvermittlerschicht aufgetragen wurde. Anschließend werden Bedingungen eingestellt, bei denen die Polymerschicht oder die Polymerverbindung mit der Haftvermittlerschicht in einer chemischen Reaktion eine kovalente Bindung eingehen.

Bevorzugt erfolgt die kovalente Verbindung der Haftvermittlerschicht mit der Polymerschicht über C-C Einfachbindungen. Bevorzugt entstehen die C-C-Einfachbindungen dadurch, dass funktionelle Gruppen an der Oberfläche der Haftvermittlerschicht mit funktionellen Gruppen der Polymerschicht reagieren. Bevorzugt sind die funktionellen Gruppen jeweils ungesättigte Kohlenstoffbindungen, insbesondere C-C Doppelbindungen. In einer besonders bevorzugten Ausführungsform weist die Polymerverbindung zur Herstellung der Polymerschicht ungesättigte Kohlenstoffbindungen auf, insbesondere Doppelbindungen, die zu Kohlenstoffeinfachbindungen vernetzbar sind, welche die Haftvermittlerschicht und die Polymerschicht miteinander verbinden.

In einer bevorzugten Ausführungsform wird die Polymerschicht erhalten, indem eine Polymerverbindung auf die Haftvermittlerschicht aufgetragen und vernetzt wird, wobei beim Vernetzen der Polymerverbindung auch die Haftvermittlerschicht mit der Polymerschicht kovalent verbunden wird.

Dies bedeutet, dass zwei Reaktionen parallel verlaufen, nämlich die Vernetzung der Polymerverbindung unter Erhalt der Polymerschicht, und die Reaktion zu einer stabilen kovalente Bindung der Haftvermittlerschicht mit der Polymerschicht. Bevorzugt weisen die Oberfläche der Haftvermittlerschicht und die Polymerverbindung dabei identische oder ähnliche funktionelle Gruppen auf, insbesondere ungesättigte Kohlenstoffbindungen.

In einer bevorzugten Ausführungsform erfolgt das Vernetzen der Polymerschicht durch Vulkanisieren. Bevorzugt wird dabei die Polymerschicht mit der Haftvermittlerschicht kovalent verbunden. Allgemein erfolgt die Vulkanisation in Gegenwart von reaktiven Hilfsstoffen und/oder Katalysatoren, welche die Vernetzung bewirken oder unterstützen. Diese Hilfsstoffe und/oder Katalysatoren können der Polymerschicht oder der Polymerverbindung vor dem Aushärten zugesetzt werden. Als Hilfsstoffe zur Vulkanisation werden beispielsweise Schwefel, Peroxide, Metallverbindungen insbesondere Metalloxide, Silane, Amine, Bisphenole, Phenolharze oder energiereiche Strahlung eingesetzt. Die Vulkanisation kann durch äußere Einflüsse induziert oder beschleunigt werden, beispielsweise durch Einwirken von Wärme oder Strahlung.

In einer bevorzugten Ausführungsform weist die Haftvermittlerschicht vor Auftragen der Polymerschicht an der Oberfläche ungesättigte Kohlenstoffbindungen auf, insbesondere Kohlenstoff Doppel- oder Dreifachbindungen. Bei der Herstellung von Plasma-Beschichtungen mit ungesättigten Kohlenwasserstoffen in Gegenwart von siliciumorganischen Verbindungen können Haftvermittlerschichten erhalten werden, die an der Oberfläche ungesättigte C-C Bindungen aufweisen. Dabei ist es bevorzugt, Ethylen oder Acetylen einzusetzen, wodurch ein relativ hoher Anteil von ungesättigten funktionellen Gruppen an der Oberfläche der Beschichtung erhalten werden kann.

In einer bevorzugten Ausführungsform ist die Polymerverbindung, die zur Herstellung der Polymerschicht eingesetzt wird, eine ungesättigte Verbindung, die insbesondere nicht aromatische Doppelbindungen enthält. Solche Polymerverbindungen können relativ gut vernetzt werden, insbesondere durch Vulkanisieren.

In einer bevorzugten Ausführungsform ist die Polymerschicht eine elastomere Schicht. Das E-Modul gemäß DIN 53457 ist bevorzugt kleiner 3000 N/mm², insbesondere kleiner 2000 N/mm². Die Polymerschicht ist bevorzugt aus einem Kautschuk erhältlich. Kautschuke eignen sich allgemein zur Herstellung von elastomeren Polymeren durch Vernetzen. Kautschuke enthalten Doppelbindungen und können daher auf einfache Weise vernetzt werden und dabei gegebenenfalls mit der Haftvermittlerschicht eine kovalente Verbindung eingehen.

In einer bevorzugten Ausführungsform weist die Polymerschicht ein Polymermaterial auf, das ausgewählt ist aus Fluorkautschuk (FKM), Ethylen-Propylen-Copolymere, wie Ethylen-Propylen-Dien-Kautschuk (EPDM), Polyacrylat-Kautschuk (ACM), Ethylen-Acrylat-Kautschuk (AEM), Butadien-Kautschuk, wie Acrylnitril-butadienkautschuk (NBR), hydrierte Acrylnitril-butadienkautschuk (HNBR), Styrol-Butadien-Kautschuk (SBR), Silikon-Kautschuke, Naturkautschuk (NR), Chloropren-Kautschuk (CR), Epichlorhydrin-Kautschuk (ECO), Polyurethan oder Epoxid-Polymere. Insbesondere besteht die Polymerschicht aus solchen Polymermaterialien. Diese Polymere sind vorteilhaft, weil sie auf relativ einfache Weise vernetzt und dabei mit der Haftvermittlerschicht verbunden werden können.

In einer Ausführungsform weisen die Polymerschicht und/oder das Substrat kein Fluorpolymer auf. In einer Ausführungsform weist das Verbundmaterial kein Fluorpolymer und/oder überhaupt keine Komponenten mit Fluoridgruppen auf. Bevorzugt ist das Substrat nicht PTFE und/oder das Verbundmaterial enthält kein PTFE. Im Stand der Technik wird vorgeschlagen, inertes PTFE, das eine niedrige Oberflächenenergie aufweist, im Plasma zu beschichten und dabei zu aktivieren. Es war überraschend, dass mit dem erfindungsgemäßen Verfahren stabile Verbundmaterialien erhalten werden können, wenn das Substrat oder das Verbundmaterial keine Fluorpolymere und insbesondere kein PTFE aufweist.

Die Polymerschicht ist unmittelbar durch die Haftvermittlerschicht mit dem Substrat verbunden. Dies bedeutet, dass zwischen dem Substrat und der Polymerschicht nur die Haftvermittlerschicht vorhanden ist, die im Plasma erzeugt wurde.

Erfindungsgemäß sind das Substrat, die Haftvermittlerschicht und die Polymerschicht nicht über ein zusätzliches Bindemittel verbunden. Es ist nicht erforderlich, die Polymerschicht mit dem plasmabeschichteten Substrat unter Einsatz eines zusätzlichen Bindemittels zu verbinden. Es wurde gefunden, dass ein hochstabiles Verbundmaterial erhalten werden kann, wenn die Polymerschicht unmittelbar auf die Haftvermittlerschicht aufgetragen wird. Erfindungsgemäß weist das Verbundmaterial daher zwischen dem Substrat, der Polymerschicht und der Haftvermittlerschicht kein zusätzliches Bindemittel auf. Auch ein Verkleben ist nicht erforderlich. Dies ist vorteilhaft, weil das Herstellungsverfahren relativ einfach ist, weil es relativ wenig Komponenten und Verfahrensschritte erfordert. Außerdem würde durch ein zusätzliches Bindemittel die Komplexität des Verbundmaterials erhöht, was zu mehr Verbindungsstellen führt und insgesamt nachteilig für die Stabilität ist.

In einer Ausführungsform der Erfindung weist das Verbundmaterial auf der Polymerschicht keine weiteren Schichten auf. Die Polymerschicht bildet dabei die äußere Schicht und die Oberfläche des Verbundmaterials. In einer bevorzugten Ausführungsform der Erfindung ist das Verbundmaterial so ausgestaltet, dass auf dem Substrat nur die Polymerschicht und die Haftvermittlerschicht vorhanden sind. In einer bevorzugten Ausführungsform der Erfindung besteht das Verbundmaterial aus dem Substrat, der Polymerschicht und der Haftvermittlerschicht.

In einer bevorzugten Ausführungsform ist die Polymerschicht nicht eine Klebstoffschicht bzw. eine haftvermittelnde Schicht, die das Substrat mit einer weiteren, zusätzlichen Schicht verbindet, die vom Substrat abgewandt ist. Die Polymerschicht kann dabei eine Trägerschicht sein, auf die mindestens eine weitere Schicht aufgetragen ist. Dies bedeutet, dass die Polymerschicht nach dem Auftragen aushärtet, ohne dass sie vor dem Aushärten mit einer weiteren Komponente verbunden wird.

In einer Ausführungsform kann auf der Polymerschicht, also auf der von dem Substrat abgewandten Seite, mindestens eine weitere Schicht vorhanden sein. Beispielsweise kann die weitere Schicht eine funktionelle Beschichtung sein, zum Beispiel zur Farbgebung oder Reibungsreduktion. Die mindestens eine zusätzliche Schicht kann nach üblichen Verfahren aufgetragen werden, beispielsweise durch nasschemisches Beschichten, wie Lackieren, Verkleben mit einem zusätzlichen Klebstoff oder durch eine weitere Plasmabeschichtung. Bevorzugt ist nicht die Polymerschicht selbst die haftvermittelnde Schicht, welche die zusätzliche Schicht mit dem plasmabeschichteten Substrat verbindet, sondern die Polymerschicht ist eine Trägerschicht.

Erfindungsgemäß ist es bevorzugt, erst das Substrat mit der Haftvermittlerschicht auszustatten und danach die Polymerschicht auf die Haftvermittlerschicht aufzutragen. Gegenstand der Erfindung ist dabei auch ein Verfahren zur Herstellung eines erfindungsgemäßen Verbundmaterials, umfassend die Schritte:
(a) Bereitstellen des Substrats,
(b) Beschichten der Substrats mit der Haftvermittlerschicht durch plasmagestützte chemische Gasphasenabscheidung,
(c) Auftragen einer Polymerverbindung auf die Haftvermittlerschicht, und
(d) Vernetzen der Polymerverbindung, wobei auch die Haftvermittlerschicht mit der Polymerschicht kovalent verbunden wird.

Dabei werden die Schritte (a) bis (d) in der angegebenen Reihenfolge ausgeführt.

In Schritt (a) wird ein geeignetes Substrat ausgewählt. Allgemein ist das Substrat ein Formköper, der jede gewünschte Form aufweisen kann, wie einen Stab, Ring, eine Platte oder ein komplexes Bauteil. Das Substrat gibt dabei bevorzugt die Form des Verbundmaterials vor. So kann zur Herstellung eines Dichtrings als Substrat ein Metallring bereitgestellt werden.

Bevorzugten weist dabei die Haftvermittlerschicht, die in Schritt (b) aufgetragen wird, an der Oberfläche ungesättigte Kohlenstoffbindungen auf. Diese reagieren beim Vernetzen der Polymerverbindung in Schritt (d) bevorzugt mit der Polymerverbindung, die bevorzugt ebenfalls reaktive Gruppen aufweist. Dadurch werden die Vorteile einer stabilen Schichtverbindung erreicht, die oben für das erfindungsgemäße Verbundmaterial beschrieben werden.

Allgemein kann in Schritt (b) das Auftragen der Haftvermittlerschicht auf das Substrat durch Reaktion im Plasma nach bekannten Verfahren erfolgen. Diesbezüglich wird auf den einleitend erörterten Stand der Technik verwiesen, in dem beispielhaft beschrieben wird, wie Plasma-Schichten aus Kohlenwasserstoffen, Silanen, Siloxanen oder Gemischen von Vorläuferverbindungen erzeugt werden. Allgemein wird das Substrat zunächst gereinigt und in eine geeignete Plasmavorrichtung eingeführt. Üblicherweise erfolgt in der Vorrichtung zunächst eine nicht-schichtbildende Vorbehandlung in einem Plasmagas, das keine schichtbildenden Vorläuferverbindungen enthält, beispielsweise in Gegenwart von Edelgasen, Sauerstoff oder Stickstoff. Dabei kann das Substrat erneut gereinigt und gegebenenfalls an der Oberfläche aktiviert werden. Anschließend werden geeignete Vorläuferverbindungen in der Gasphase zugeführt und plasmagestützte chemische Gasphasenabscheidung wird durchgeführt. Die Dicke, die Zusammensetzung und das Wachstum der Schicht können durch bekannte Maßnahmen kontrolliert werden, indem beispielsweise die Menge und Konzentration der Vorläuferverbindungen, die Temperatur, die Prozessleistung, der Druck, die Beschichtungsdauer, die Zuführung von Inertgas und sonstige Parameter variiert werden. Nach Ausbildung der gewünschten Beschichtung wird der PE-CVD-Prozess gestoppt, indem beispielsweise das Substrat aus der Vorrichtung entfernt wird; oder indem der Leistungseintrag oder der Zufluss von Vorläuferverbindungen unterbrochen wird. Entsprechende Verfahren und Modifikationen sind bekannt und in der Literatur hinlänglich beschrieben. Lediglich beispielhaft wird dazu auf das Lehrbuch "Advanced Plasma Technology", d'Agostino *et al.* (Editor), Verlag Wiley-VCH, 2008, verwiesen.

Bei dem erfindungsgemäßen Verfahren ist vorteilhaft, dass im Plasma mit geringem Materialeinsatz eine gleichmäßige, dünne und stabile Haftvermittlerschicht erzeugt werden kann. Dagegen werden bei bekannten nasschemischen Verfahren Tauchbäder oder Sprühverfahren eingesetzt und es muss eine relativ dicke Haftvermittlerschicht erzeugt werden, um das Substrat gleichmäßig und vollständig zu beschichten. Dadurch werden relativ große Mengen von Bindemittel verbraucht, was aus wirtschaftlichen und ökologischen Gründen unerwünscht ist.

Das Aufbringen der Polymerschicht in Schritt (c) kann nach üblichen Verfahren erfolgen. Dabei ist es bevorzugt, dass eine Polymerverbindung nicht in fester Form, und dabei insbesondere in flüssiger, pastöser oder hochviskoser Form aufgebracht und anschließend zu der Polymerschicht verfestig wird. Dabei wird die Polymerverbindung insbesondere als Schmelze oder Gemisch mit einem Lösungsmittel aufgetragen. Das Verfestigen erfolgt dabei durch Aushärten und/oder Vernetzen. Das Aufbringen der flüssigen, pastösen oder hochviskosen Polymerverbindung kann nach üblichen Formgebungsverfahren erfolgen, beispielsweise durch Spritzgießen (Injection Molding), Pressverfahren (Compression molding) oder Transferverfahren (Transfer moulding). Dabei wird das Substrat mit der Haftvermittlerschicht aus Schritt (b) bevorzugt in eine Form gegeben. Dabei wird eine Formmasse in eine Kammer auf das beschichtete Substrat eingespritzt, in der sie unter Wärme und Druck vernetzt bzw. aushärtet. Das Verfahren ist insbesondere zur Herstellung von Elastomerbauteilen, wie etwa Dichtungen, geeignet. Bei der Aushärtung unter Wärme und Druck kann parallel die Ausbildung von kovalenten Bindungen der Polymerschicht zu der Haftvermittlerschicht erfolgen.

Bei Schritt (c) wird die Polymerschicht unmittelbar auf die Haftvermittlerschicht aufgebracht. Der Einsatz eines zusätzlichen Bindemittels ist daher nicht erforderlich. Dies ist vorteilhaft, weil die Komplexität des Systems und des Verfahrens verringert wird und die bekannten Probleme bei der Verwendung von Bindemitteln, wie gleichmäßiger Auftrag und hoher Materialverbrauch durch Tauchbäder und Sprühverfahren, vermieden werden.

In einer bevorzugten Ausführungsform können die Polymerschicht und die Polymerverbindung Additive enthalten. Insbesondere sind Additive bevorzugt, die das Aushärten fördern, wie Vernetzungshilfsstoffe und Katalysatoren zur Vulkanisation. Als Vernetzungshilfsstoffe können insbesondere Schwefel, Peroxide, Metallverbindungen insbesondere Metalloxide, Silane, Amine, Bisphenole, oder Phenolharze enthalten sein. Die Polymerschicht kann auch übliche Additive enthalten, welche die Eigenschaften in gewünschter Weise modifizieren, wie Füllstoffe, Verarbeitungshilfsmittel, Bindehilfsmittel, Lichtschutzmittel oder Farbstoffe. Als Füllstoffe können beispielsweise mineralische Füllstoffe, Kieselsäuren oder Ruß enthalten sein.

Gegenstand der Erfindung ist auch die Verwendung einer Haftvermittlerschicht zum Verbinden des Substrats mit einer Polymerschicht. Dabei ist die Haftvermittlerschicht durch PE-CVD erhältlich, die mit einem Gemisch von Vorläuferverbindungen durchgeführt wird, das mindestens einen ungesättigten Kohlenwasserstoff und mindestens eine siliciumorganische Verbindung enthält. Die Verwendung erfolgt dabei insbesondere mit den erfindungsgemäßen Verbundmaterialien.

Die erfindungsgemäßen Verbundmaterialien zeichnen sich durch eine hohe Stabilität aus. Das Substrat kann nur durch starke mechanische Kräfte von der Polymerschicht gelöst werden. Daher können die Verbundmaterialien für Anwendungen eingesetzt werden, bei denen starke mechanische Kräfte auf die Materialien wirken. Alternativ können Anwendungen im Kontakt mit materialbeanspruchenden und/oder aggressiven flüssigen Medien von Vorteil sein.

Die Verbundmaterialien sind bevorzugt durch eine hohe Haftkraft oder Haftfestigkeit charakterisiert. Somit sind bevorzugt hohe Trennkräfte erforderlich, um die Polymerschicht von dem Substrat abzulösen. Die Haftfestigkeit von Schichtmaterialien wird bevorzugt gemäß der ASTM D429 ermittelt. Die Haftfestigkeit von Polymerschichten auf Metallen wird dabei bevorzugt im 90° Schälversuch in Anlehnung an Methode B ermittelt. Bevorzugt ist dabei die Trennkraft größer 2 N/mm, insbesondere größer 5 N/mm, besonders bevorzugt größer 7,5 N/mm, besonders bevorzugt größer 10 N/mm. Bevorzugt zeigt sich dabei ein Versagensbild im Elastomermaterial, also in der Polymerschicht (Versagensbild R gemäß den Ausführungsbeispielen), und nicht eine Ablösung der Schichten voneinander.

Gegenstand der Erfindung ist auch die Verwendung des erfindungsgemäßen Verbundmaterials als Dichtungsartikel oder zur Herstellung eines Dichtungsartikels. Die erfindungsgemäßen Verbundmaterialien eignen sich wegen der hohen Stabilität in besonderem Maße als Dichtungsartikel. Dichtungsartikel müssen bei hohen mechanischen Belastungen über lange Zeiträume eine gleichbleibende Dichtwirkung erbringen. Dichtungsartikel, beispielsweise aus Metall, werden dazu oft mit Beschichtungen ausgestattet, welche die Stabilität, die Verformbarkeit oder die Benetzbarkeit mit Dichtstoffen modifizieren. Es besteht ein hoher Bedarf nach Dichtungsartikeln, die auch bei lang anhaltender Benutzung nicht durch Abrieb, Risse oder sonstige mechanische Schäden verändert werden.

Gegenstand der Erfindung ist auch ein Dichtungsartikel, der ein erfindungsgemäßes Verbundmaterial enthält oder daraus besteht. Der Dichtungsartikel kann ein statischer oder ein dynamischer Dichtungsartikel sein. Statische Dichtungen sind beispielsweise Federn, Flanschdichtungen, Steckverbindungen (z.B. Plug & Seal), Metall-O-Ringe, Ventile, Flüssigdichtungen oder integrierte statische Dichtungen auf metallischen Substraten (zum Beispiel Elastomerdichtungen auf metallischen Bipolarplatten für Brennstoffzellenanwendungen). Dynamische Dichtungen, wie rotatorische Dichtungen, dienen zur Abdichtung bewegter Maschinenteile, die eine gemeinsame, bewegte Grenzfläche aufweisen. Bei einer dynamischen Dichtung bewegen sich die Dichtelemente relativ zueinander. Bei einer rotatorischen Dichtung ist die Relativbewegung der Dichtelemente rotatorisch. Eine dynamische Dichtung ist durch eine beträchtliche Bewegung dieser Grenzfläche charakterisiert, die bei statischen Dichtungen fehlt. Der typische Anwendungsfall einer rotatorischen Dichtung ist die Abdichtung einer rotierenden Welle gegen ein stehendes Gehäuse.

Bevorzugt ist der Dichtungsartikel eine Gleitringdichtung, ein Radialwellendichtring, ein Axialwellendichtring eine Labyrinthwellendichtung, eine Flachdichtung, ein Kolbenring, eine Feder oder eine Spezialdichtung.

Die erfindungsgemäßen Verbundmaterialien eignen sich besonders für Dichtungsartikel, weil sie zum einen außerordentlich stabil und beständig sind, zum anderen verschiedene sehr unterschiedliche Werkstoffe enthalten können. Die hohe Stabilität ist vorteilhaft, weil Dichtungselemente oft dauerhaft hohen mechanischen Belastungen ausgesetzt sind, die zu Abrieb und Beschädigungen führen können, insbesondere bei längerer Betriebsdauer. Die Kombinierbarkeit unterschiedlicher Werkstoffe ist vorteilhaft, weil Dichtungsmaterialien oft eine weiche, anpassbare Polymerkomponente und eine harte bzw. starre Komponente, beispielsweise einen Metallkern, aufweisen, die stabil und dauerhaft miteinander verbunden werden müssen.

Das Verbundmaterial ist auch für weitere Anwendungen geeignet, bei denen stabile Beschichtungen und die Kombinierbarkeit von unterschiedlichen Werkstoffen von Bedeutung sind, wie Magnetanker, Faltenbälge oder Membranen.

Die erfindungsgemäßen Verbundmaterialien, Verfahren und Verwendungen lösen die Aufgabe, die der Erfindung zugrunde liegt. Es werden Verbundmaterialien bereitgestellt, bei denen eine Vielzahl verschiedener Substrate mit verschiedenen weiteren Materialien stabil und dauerhaft verbunden werden kann. Insbesondere ermöglicht die Erfindung eine stabile Verbindung von Metallen mit Polymeren oder von verschiedenen Polymeren miteinander. Die Verbundmaterialien bestehen aus üblichen Komponenten. Sie sind durch relativ einfache Verfahren in wenigen Schritten erhältlich. Die Haftvermittlerschichten auf Basis von ungesättigten Kohlenwasserstoffen und siliciumorganischen Verbindungen haften gut auf einer Vielzahl von verschiedenen Substraten und ermöglichen eine stabile Verbindung mit einer Vielzahl weiterer, unterschiedlicher Materialien.

### Figuren

Figur 1 zeigt Fotografien der Beschichtungen auf Edelstahl-Grundkörpern gemäß Vergleichsbeispiel 1 (Fig. 1a) und Beispiel 2 (Fig. 1b). Bei Vergleichsbeispiel 2 hat sich die instabile dunkle Beschichtung weitgehend vom hellen Edelstahlsubstrat abgelöst.
Dagegen zeigt Beispiel 2 eine stabile dunkle Beschichtung.
Figur 2 zeigt Fotografien der Spezialdichtung gemäß den Beispielen 3 (Vergleich, Fig. 2a) und 4 (Fig. 2b), die mit Haftvermittlerschichten und Elastomerschichten ausgestattet sind.
Fig. 2b zeigt das Bauteil mit der stabilen Elastomerschicht (dunkel, mittig). Fig. 2a zeigt, dass sich das Elastomer weitgehend vom hellen, mittigen Grundkörper ablöst.
Figur 3 zeigt IR-Spektren von Schichtsystem I und II, die gemäß Beispiel 47 gemessen wurden.
Figur 4 zeigt IR-Spektren von Schichtsystem II, VI und VII, die gemäß Beispiel 48 gemessen wurden.

### Ausführungsbeispiele

### Herstellung der Beschichtung

Verschiedene Grundkörper werden in einem Plasma-unterstützten Prozess der chemischen Gasphasenabscheidung mit einer Beschichtung versehen. Dazu wird eine Niederdruck-Plasma-Anlage für eine asymmetrische, kapazitiv gekoppelte Radiofrequenz-Entladung verwendet. Die Grundkörper (Substrate) werden mit Kontakt auf der Elektrode positioniert. Bei diesem Prozess wird als Kohlenstoffquelle und wesentliche schichtbildende Vorläuferverbindung Acetylen oder Ethylen sowie ggfs. als siliciumorganische Verbindung eine Alkylsilan- oder Siloxan-Verbindung verwendet. Der Zusatz von weiteren Reaktiv- Gasen, bspw. Sauerstoff, Argon, Stickstoff, ist ebenfalls möglich. Durch Anregung mit elektromagnetischer Strahlung, beispielsweise bei Radiofrequenz, werden diese Gase bei Prozessdrücken von wenigen Pascal in den Plasmazustand versetzt. Die Moleküle werden gespalten und kondensieren als Kohlenstoff-reiche Schicht, die beim zusätzlichen Einsatz der siliciumorganischen Verbindung mit Siliciumanteil versehen ist, auf der Oberfläche des Grundkörpers. Zur besseren Anbindung der Schicht an die Grundkörper werden diese zunächst in einem nicht schichtbildenden Plasma, bspw. aus Argon und/oder Sauerstoff, aktiviert. Hierbei können je nach Beschaffenheit der Grundkörperoberfläche Fragmente von der Oberfläche in die Plasmaphase übergehen und in die Beschichtung mit eingebaut werden.

Prinzipiell ist es möglich und auch gängige Praxis, mehrere Prozessabschnitte zu einem Gesamtprozess zu vereinen. So können z.B. die Prozessgaszusammensetzungen im Laufe des Prozesses variiert werden und die lokale Schichtzusammensetzung graduell oder stufenartig beeinflusst werden.

Wenn nicht weiter spezifiziert werden in den folgenden Ausführungsbeispielen Substrate aus Edelstahl (polierte, entfettete Edelstahl-Streifen Typ 1.4016 mit den Abmessungen Breite x Länge 20 mm x 100 mm) verwendet.

Als Polymerkomponenten werden auf die beschriebenen Haftvermittlerschichten folgende Dichtungswerkstoffe aufgebracht:

**Tabelle 1: Verwendete Dichtungswerkstoffe**

| **Bezeichnung** | **Polymer** | **Vernetzungsmechanismus** | **Hauptfüllstoff** |
|---|---|---|---|
| FKM I | Fluorkarbonkautschuk | Bisphenol | Ruß |
| FKM II | Fluorkarbonkautschuk | Peroxid | niedrig gefüllt |
| EPDM I | Ethylen- Propylen- Dien-Kautschuk | Peroxid | Ruß |
| HNBR I | Hydrierter Acryl-Nitrilbutylkautschuk | Peroxid | Ruß |
| ACM I | Acrylkautschuk | Schwefel-Seife | Ruß |

### Beispiele 1 und 2: Edelstahl-Streifen mit DLC- und Si-DLC-Schichten

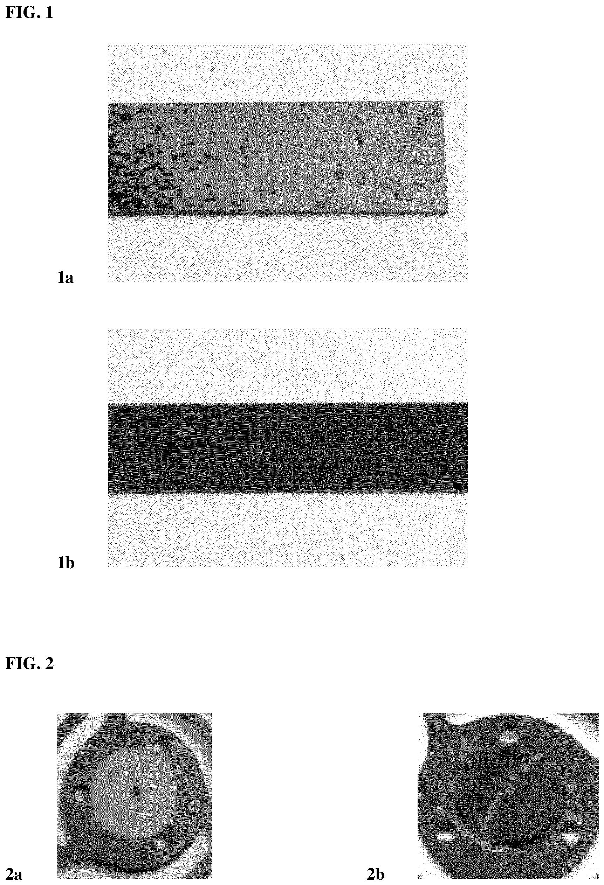

Polierte Edelstahl-Substrate werden mit Ethanol gereinigt und im oben beschriebenen Plasmaverfahren beschichtet. Dazu werden die Substrate zunächst ein einem nicht schichtbildenden Argonplasma (Prozessgasfluss: 80 sccm Argon, Prozessleistung: 300 W) aktiviert, bevor die schichtbildenden Prozesse eingeleitet werden. Schichtsystem I (Beispiel 1, Vergleich) wird aus einem reinen Kohlenwasserstoffprozess (Prozessgasfluss: 60 sccm Acetylen, Prozessleistung: 400 W) abgeschieden. Schichtsystem II (Beispiel 2) besteht zunächst aus einer siliciumorganisch angereicherten Schicht (Prozessgasfluss: 30 sccm HMDSO; Prozessleistung: 400 W), die dann in eine kohlenstoff-reiche Schicht (Prozessgasfluss: 60 sccm Acetylen, Prozessleistung: 400 W) graduell übergeht. Fotografien der Prüfkörper sind in Fig. 1 gezeigt. Das Schichtsystem I ist auf Edelstahl nicht stabil und platzt ab, so dass das helle Edelstahlsubstrat mit Resten der abgelösten, dunkleren Beschichtung zu sehen ist (Fig. 1a). Dagegen ist Schichtsystem II stabil, so dass die dunkle Beschichtung das Substrat vollständig abdeckt (Fig. 1b). Hohe Spannungen in der Beschichtung führen zu Schichtversagen und Delamination. Durch den Einbau von Si-Funktionalitäten werden die Spannungen reduziert und stabile Beschichtungen erzeugt.

### Beispiele 3 und 4: Vergleich der Schichtsysteme I und II bei einem Dichtungsprodukt

Ein metallischer Grundkörper einer Spezialdichtung (Mäanderfeder, polierter, entfetteter Edelstahl) wird mit den in den Beispielen 1 und 2 beschriebenen Schichtsystemen versehen. Anschließend wird in einem Transfermolding-Prozess partiell FKM I appliziert und vulkanisiert. Die Haftung der Elastomerkomponente auf dem Grundkörper wird manuell überprüft, indem die Auflage mit einem Werkzeug parallel zur Haftfläche abgeschoben wird. Bei dem Verbund mit Schichtsystem I (Beispiel 3, Vergleich) lässt sich die Elastomerkomponente leicht entfernen. Der Verbund versagt dabei in der Grenzfläche zwischen Haftvermittlerschicht und Metall-Grundkörper, wobei die Haftvermittlerschicht am Elastomer verbleibt. Bei dem Verbund mit Schichtsystem II (Beispiel 4) lässt sich die Elastomerkomponente nicht abschieben. Das Elastomer haftet auf der Grundfläche und versagt im Material. Die Fig. 2 zeigt Fotografien der Edelstahl-Bauteile gemäß den Beispielen 3 (Fig. 2a) und 4 (Fig. 2b). Fig. 2b zeigt das erfindungsgemäße Bauteil mit der darauf aufgebrachten stabilen Elastomerschicht (dunkel, mittig). Dagegen zeigt Fig. 2a, dass sich das Elastomer bei Vergleichsbeispiel 3 vom hellen Grundkörper abgelöst hat.

### Beispiele 5 bis 10: Vergleich Haftungsvermittlung zu HNBR-Elastomer

Metallische Grundkörper aus Edelstahl werden mit den in Beispiel 1 beschriebenen Schichtsystemen beschichtet. Weiterhin werden noch die Schichtsysteme III bis V hergestellt. Schichtsystem III besteht ähnlich wie System II aus einer siliciumorganisch angereicherten Schicht (Prozessgasfluss: 90 sccm TMS; Prozessleistung: 400 W), die dann in eine kohlenstoffreiche Schicht (Prozessgasfluss: 60 sccm Acetylen, Prozessleistung: 400 W) graduell übergeht. Schichtsystem IV basiert auf System II, zusätzlich werden aber noch 100 sccm Sauerstoff beigemischt. Schichtsystem V verwendet bei ansonsten gleichen Prozessbedingungen Ethylen (Prozessgasfluss: 60 sccm Ethylen) als Kohlenstoffspender anstelle von Acetylen.

Nach Applikation der Schichtsysteme auf den Grundkörpern werden sie in einem Compression-Molding-Prozess (CM-Prozess) mit einer Lage HNBR I versehen. Dazu wird die unvulkanisierte Elastomer-Mischung auf die Metallstreifen aufgelegt und unter Druck und bei Temperatur an den beschichteten Grundkörper anvulkanisiert (Prozessbedingungen: T = 180°C, p = 230 bar, t = 5 min). Nach dem Vulkanisationsprozess und dem anschließenden Nachheizen zur vollständigen Vernetzung des Elastomers werden aus der erkalteten Elastomerplatte Prüfkörper ausgestanzt und geschliffen. Für die Schälprüfung entsteht ein Probekörper bestehend aus einem starren, metallischen Grundkörper, einer Plasma-Haftvermittlerschicht und einer darauf aufvulkanisierten 4 mm dicken Elastomerauflage.

Zur Bewertung des Verbundes wird eine 90°-Schälprüfung in Anlehnung an ASTM D429 Methode B durchgeführt. Die Prüfgeschwindigkeit beträgt 100 mm/min. Gemessen werden Trennkräfte in N/mm. Zusätzlich zu den Trennkräften wird zudem das Versagensbild angegeben. R bezeichnet hierbei ein Versagen im Elastomer, RC das Versagen zwischen Elastomer und Haftvermittler, MC zwischen Metall und Haftvermittler sowie MR zwischen Metall und Elastomer. Ergänzend zum Versagensbild R kann eine Zahlenangabe erfolgen, die das Versagensbild genauer beschreibt. Dabei steht 100 für 100%. So bezeichnet R100 eine verbleibende Elastomerschicht mit 100 % Bedeckung auf dem Haftvermittler, d.h. der Riss geht vollständig durch das Elastomer. Ein solches Versagensbild entspricht den Maximalanforderungen, weil hierbei die Adhäsion zwischen Elastomer und starrem Substrat (Metall oder Kunststoff) größer ist als die Kohäsion des Elastomers.

Die Ergebnisse sind in Tabelle 2 zusammengefasst. Sie zeigen, dass die Prüfkörper mit den erfindungsgemäß erzeugten Haftvermittlerschichten hohe Stabilitäten aufweisen. Besonders vorteilhaft ist, dass das Versagensprofil R100 erreicht wird, das den Maximalanforderungen entspricht. Dagegen die Prüfkörper gemäß den Vergleichsbeispielen, die keine Haftvermittlerschicht oder eine Haftvermittlerschicht nur aus DLC aufweisen, instabil.

**Tabelle 2: Schälprüfung von Edelstahl-HNBRI-Verbunden**

| **Beispiel** | **Haftschicht** | **Vorläuferverbindung** | **Trennkräfte [N/mm]** | **Versagensbild** |
|---|---|---|---|---|
| 5 (Vergleich) | ohne | - | 0 | MR |
| 6 (Vergleich) | I | Acetylen | 0 | RC |
| 7 | II | HMDSO + Acetylen | 6,4 | R100 |
| 8 | III | TMS + Acetylen | 5,6 | R100 |
| 9 | IV | HMDSO + Acetylen + O2 | 5,9 | R100 |
| 10 | V | HMDSO + Ethylen + O2 | 4,2 | R100 |

### Beispiele 11 bis 13: Vergleich Haftungsvermittlung zu FKM II-Elastomer

Analog zu dem Vorgehen im vorangegangenen Beispiel werden Grundkörper aus Edelstahl mit den Schichtsystemen I und II versehen. Als Elastomerkomponente für die Schälprüfkörper wird dieses Mal FKM II verwendet. Die Prüfung und Bewertung der Haftung erfolgt analog zum vorangegangen Beispiel.

Die Ergebnisse sind in Tabelle 3 zusammengefasst. Sie zeigen, dass der Prüfkörper mit der erfindungsgemäß erzeugten Haftvermittlerschicht eine hohe Stabilität aufweist. Dagegen die Prüfkörper gemäß den Vergleichsbeispielen instabil, die keine Haftvermittlerschicht oder eine Haftvermittlerschicht nur aus DLC aufweisen.

**Tabelle 3: Schälprüfung von Edelstahl-FKMII-Verbunden**

| **Beispiel** | **Haftschicht** | **Vorläuferverbindung** | **Trennkräfte [N/mm]** | **Vers agensbild** |
|---|---|---|---|---|
| 11 (Vergleich) | ohne | - | 0 | MR |
| 12 (Vergleich) | I | Acetylen | 0 | MC |
| 13 | II | HMDSO + Acetylen | 12,1 | R100 |

### Beispiele 14 bis 26: Haftung mit verschiedenen Haftvermittlerschichten und Elastomeren

Metallische Grundkörper aus Edelstahl werden mit verschiedenen Si-Kohlenwasserstoff-Schichtsystemen zur Haftvermittlung beschichtet. Schichtsystem II besteht wie schon beschrieben zunächst aus einer siliciumorganisch angereicherten Schicht (Prozessgasfluss: 30 sccm HMDSO; Prozessleistung: 400 W), die dann in eine Kohlenstoff-reiche Schicht (Prozessgasfluss: 60 sccm Acetylen, Prozessleistung: 400 W) graduell übergeht. Schichtsystem VI basiert auf den gleichen Prozessparametern, jedoch wird der siliciumorganische Anteil im Prozessgasgemisch bis Prozessende konstant gehalten. Bei Schichtsystem VII wird der siliciumorganische Precursor in der letzten Phase des Prozesses auf 4 sccm bei ansonsten gleichen Prozessparametern abgesenkt. Zum Vergleich wird außerdem Schichtsystem VIII untersucht, das ebenfalls auf Schichtsystem II basiert. Hier wird allerdings nur HMDSO als Precursor verwendet, die übrigen Prozessparameter entsprechen Schichtsystem II. Aus den so hergestellten Grundkörpern werden anschließend Prüfkörper mit verschiedenen Mischungen hergestellt, die analog zu dem zuvor beschriebenen Beispielen in 90°-Schälprüfungen charakterisiert werden.

Die Ergebnisse sind in Tabelle 4 zusammengefasst. Sie zeigen, dass die Prüfkörper mit den erfindungsgemäß erzeugten Haftvermittlerschichten hohe Stabilitäten aufweisen. Dagegen sind die Prüfkörper gemäß den Vergleichsbeispielen, die keine Haftvermittlerschicht, eine Haftvermittlerschicht nur aus DLC, oder eine Haftvermittlerschicht nur aus HMDSO erzeugt aufweisen, instabil bzw. sie zeigen keine Haftung zwischen Metall und Elastomer.

**Tabelle 4: Schälprüfung von Edelstahl-Elastomer-Verbunden**

| **Beispiel** | **Haftschicht** | **Vorläuferverbindung** | **Mischung** | **Trennkräfte [N/mm]** | **Vers agensbild** |
|---|---|---|---|---|---|
| 14 (Vergleich) | ohne | - | FKM I | 0 | MR |
| 15 | II | HMDSO + Acetylen | FKM I | 7,7 | R100 |
| 16 | VI | HMDSO + Acetylen | FKM I | 6,6 | R100 |
| 17 | VII | HMDSO + Acetylen | FKM I | 7,5 | R100 |
| 18 (Vergleich) | VIII | HMDSO | FKM I | 0 | RC |
| 19 (Vergleich) | ohne | - | FKM II | 0 | MR |
| 20 | II | HMDSO + Acetylen | FKM II | 12,1 | R100 |
| 21 | VI | HMDSO + Acetylen | FKM II | 9,1 | R100 |
| 22 | VII | HMDSO + Acetylen | FKM II | 8,4 | R100 |
| 23 (Vergleich) | ohne | - | EPDM I | 0 | MR |
| 24 | II | HMDSO + Acetylen | EPDM I | 2,8 | R100 |
| 25 | VI | HMDSO + Acetylen | EPDM I | 3,4 | R100 |
| 26 | VII | HMDSO + Acetylen | EPDM I | 3,3 | R100 |

### Beispiele 27 bis 40: Haftung Si-DLC auf Metall- und Kunststoffsubstraten

Verschiedene Substrate werden mit den Si-dotierten Kohlenwasserstoffschichten versehen. Der vorgeschaltete Aktivierungsprozess ist in allen Fällen gleich. Als metallische Substrate werden Aluminium (Al 99,5) und Stahl (DD11) in den Abmessungen der zuvor verwendeten Edelstahlsubstrate verwendet. Zusätzlich werden folgende Kunststoffsubstrate (Breite x Länge: 25 mm x 100 mm) verwendet: Polyamid 6.6 (PA66), Polyamid 6.6 mit 30% Glasfaser-Füllung (PA66GF30) und Polyphenylensulfid mit 40% Glasfaser-Füllung (PPSGF40). Nach der Beschichtung werden Schälprüfkörper wie in den zuvor beschriebenen Ausführungsbeispielen hergestellt und geprüft. Als Elastomerkomponente wird FKMI verwendet.

Die Ergebnisse sind in Tabelle 5 zusammengefasst. Sie zeigen, dass die Prüfkörper mit den erfindungsgemäß erzeugten Haftvermittlerschichten sowohl auf Metallen als auch auf Kunststoffen hohe Stabilitäten aufweisen. Dagegen sind die Prüfkörper gemäß den Vergleichsbeispielen, die keine Haftvermittlerschicht oder eine Haftvermittlerschicht nur aus DLC aufweisen, instabil.

**Tabelle 5: Schälprüfung verschiedener Kunststoff- bzw. Metall-FKMI-Verbunde**

| **Beispiel** | **Haftschicht** | **Vorläuferverbindung** | **Substrat** | **Trennkräfte [N/mm]** | **Vers agensbild** |
|---|---|---|---|---|---|
| 27 (Vergleich) | ohne | - | DD11 | 0 | MR |
| 28 | II | HMDSO + Acetylen | DD11 | 8,1 | R100 |
| 29 | VI | HMDSO + Acetylen | DD11 | 8,1 | R100 |
| 30 | VII | HMDSO + Acetylen | DD11 | 8,3 | R100 |
| 31 (Vergleich) | ohne | - | PPSGF40 | 0 | MR |
| 32 | II | HMDSO + Acetylen | PPSGF40 | 5,9 | R100 |
| 33 | VI | HMDSO + Acetylen | PPSGF40 | 6,4 | R100 |
| 34 | VII | HMDSO + Acetylen | PPSGF40 | 6,3 | R100 |
| 35 (Vergleich) | ohne | - | Al 99,5 | 0 | MR |
| 36 | II | HMDSO + Acetylen | Al 99,5 | 6,7 | R100 |
| 37 (Vergleich) | ohne | - | PA66 | 0 | MR |
| 38 | II | HMDSO + Acetylen | PA66 | 6,4 | R100 |
| 39 (Vergleich) | ohne | - | PA66G F30 | 0 | MR |
| 40 | II | HMDSO + Acetylen | PA66GF30 | 5,7 | R100 |

### Beispiele 41 und 42: Haftung Si-DLC bei PTFE-ACM-Verbunden

Analog zu den vorangegangenen Beispielen werden Thermoplast-Elastomer-Schälstreifen hergestellt. Als Kunststoff-Substrat wird PTFE mit 25% Glasfasern (Abmessungen Breite x Länge 25 mm x 100 mm) verwendet. Als Haftvermittler kommt Schichtsystem II zum Einsatz und als Elastomer ACM I (Polyacrylat-Kautschuk) Das übrige Vorgehen entspricht dem vorab beschriebenen mit der Ausnahme, dass die Schälstreifen nach der Vulkanisation nicht mehr nachgeheizt werden.

Die Ergebnisse sind in Tabelle 6 zusammengefasst. Sie zeigen, dass der Prüfkörper mit der erfindungsgemäß erzeugten Haftvermittlerschicht eine hohe Stabilität aufweist. Dagegen ist der Prüfkörper gemäß dem Vergleichsbeispiel 41 instabil, die keine Haftvermittlerschicht aufweist. Wie Vergleichsbeispiel 41b zeigt, vermittelt auch die mit HMDSO erzeugte Schicht VIII keine Haftung zwischen dem PTFE und dem ACM.

**Tabelle 6: Schälprüfung von PTFE-ACM-Verbunde**

| **Beispiel** | **Haftschicht** | **Vorläufer verbindung** | **Trennkräfte [N/mm]** | **Vers agensbild** |
|---|---|---|---|---|
| 41 (Vergleich) | ohne | - | 0 | MR |
| 41b (Vergleich) | VIII | HMDSO | 1,4 | RC |
| 42 | II | HMDSO + Acetylen | 4,2 | R100 |

### Beispiel 43: Medienstabilität der Haftverbunde (Wasserlagerung)

Es werden Schälprüfkörper analog zu den vorangegangenen Beispielen aus Edelstahl und FKM I sowie aus Edelstahl und EPDM I hergestellt. Als Haftvermittler fungiert Schichtsystem II. Vor der Schälprüfung werden die Prüfkörper für 72 h bei 60 °C in Wasser gelagert. Bei der anschließenden Schälprüfung weisen die Prüfkörper eine vergleichbare Stabilität auf wie die ungelagerten Pendants, mit dem Versagensbild R100 im Elastomer. Die Versuche zeigen, dass das Verbundmaterial eine hohe Beständigkeit aufweist.

### Beispiel 44: Medienstabilität der Haftverbunde (Luftfeuchtigkeit)

Es werden Schälprüfkörper analog zu den vorangegangenen Beispielen aus Edelstahl und FKM I sowie aus Edelstahl und EPDM I hergestellt. Als Haftvermittler fungiert Schichtsystem II. Vor der Schälprüfung werden die Prüfkörper für 72 h bei 60 °C in 100 % Luftfeuchte gelagert. Bei der anschließenden Schälprüfung weisen die Prüfkörper eine vergleichbare Stabilität auf wie die ungelagerten Pendants, mit dem Versagensbild R100 im Elastomer. Die Versuche zeigen, dass das Verbundmaterial eine hohe Beständigkeit aufweist.

### Beispiel 45: Medienstabilität der Haftverbunde (Weichmacher)

Es werden Schälprüfkörper analog zu den vorangegangenen Beispielen aus Edelstahl und FKM I sowie aus Edelstahl und EPDM I hergestellt. Als Haftvermittler fungiert Schichtsystem II. Vor der Schälprüfung werden die Prüfkörper für 168 h bei 80 °C in einen Weichmacher (Dioctylsebacat) gelagert. Bei der anschließenden Schälprüfung weisen die Prüfkörper eine vergleichbare Stabilität auf wie die ungelagerten Pendants, mit dem Versagensbild R100 im Elastomer. Die Versuche zeigen, dass das Verbundmaterial eine hohe Beständigkeit aufweist.

### Beispiel 46: PTFE Kleben

Ungefüllte PTFE-Prüfkörper (Abmessungen Breite x Länge 25 mm x 100 mm) werden mit Schichtsystem II vorbehandelt und anschließend mit einem heißaushärtenden Epoxid-Klebstoff (Delomonopox HAT 2860) zu Scherprüfkörpern verklebt, die Überlappungsbreite beträgt dabei 25 mm, die Überlappungslänge 12,5 mm. Der Klebstoff wird bei 150°C für 55 min ausgehärtet. Die Scherprüfung findet im erkalteten Zustand nach DIN EN 1465 statt. Die Prüfgeschwindigkeit beträgt 30 mm/min. Alle Prüfkörper waren stabil und versagten bei der Schälprüfung im PTFE bzw. zwischen PTFE und Haftvermittlerschicht. Zu Vergleichszwecken werden zudem Scherprüfkörper aus PTFE-Streifen ohne Haftvermittlerschichten hergestellt. Hier konnte keine Haftung hergestellt werden und somit auch keine Prüfung durchgeführt werden.

### Beispiel 47: Chemische Funktionalitäten in den Beschichtungen (FTIR-Spektren und Raman-Untersuchung)

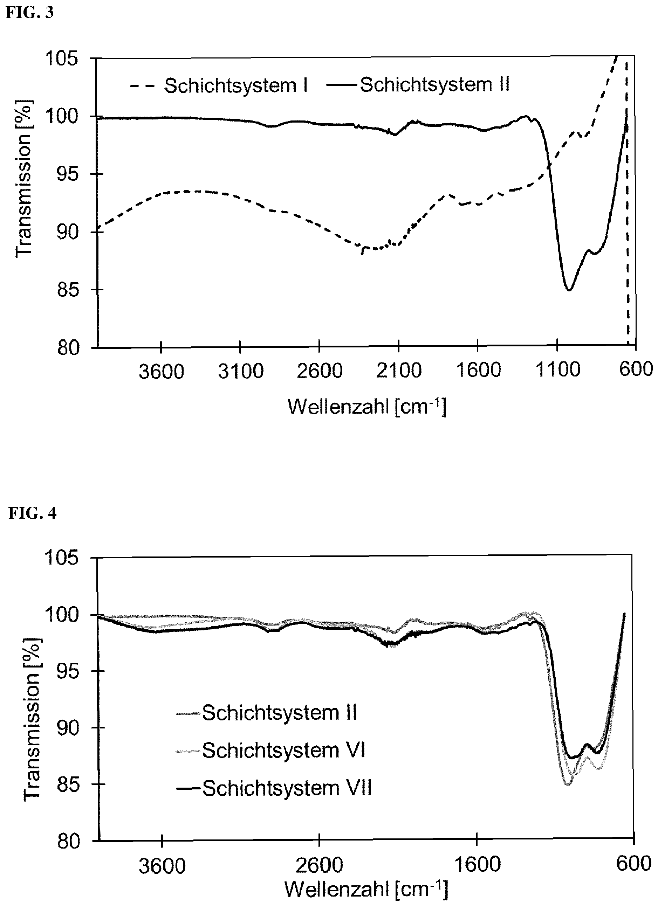

Die Schichtsysteme aus den Beispielen 1 und 2 werden auf Aluminium-Folie abgeschieden und mittels FT-IR (ATR-Modus, Germanium-Kristall) hinsichtlich ihrer chemischen Funktionalität charakterisiert. Die Sensitivität dieser Methode umfasst die ersten Mikrometer einer Oberfläche, d.h. hier ist wahrscheinlich, dass Anteile des Substrats im Spektrum erscheinen. Da sich das Substrat aber chemisch deutlich von den Beschichtungen unterscheidet, sollten diese Anteile vernachlässigbar sein. Die IR-Spektren sind in Fig. 3 dargestellt. An beiden Spektren ist ersichtlich, dass die in WO 01/61069 A2 beschriebenen Banden um 3300 cm⁻¹ nicht deutlich ausgebildet sind. Dies begründet sich in der hoch vernetzten und wenig geordneten Struktur der DLC-Schicht. Ferner weist Schichtsystem II im Gegensatz zu Schichtsystem I deutliche sililziumorganische Anteile in der Schicht auf (siehe Signal um etwa 800 bzw. 1000 cm⁻¹). Die einbettende DLC-Matrix ist im IR-Spektrum wenig spezifizierbar.

Das Schichtsystem II wird zur genaueren Charakterisierung der Kohlenstoffbindungsumgebung zudem mittels Raman auf seine sp²-Anteile untersucht. Im Durchschnitt liegt der Graphit-Anteil bei 62%. Ein signifikanter Anteil der KohlenstoffAtome weist also Doppelbindungen auf.

### Beispiel 48: Chemische Funktionalitäten in den Beschichtungen Si-DLC (FTIR-Messungen)

Analog zum vorangegangenen Beispiel werden die Schichtsysteme VI und VII, die hergestellt wurden wie oben beschrieben, mittels FTIR untersucht Auch hier ist unabhängig von der Ausgestaltung des Schichtsystems der siliciumorganische Anteil in der Beschichtung deutlich erkennbar (Fig. 4). Tendenziell neigen die Schichtsysteme mit durchlaufender Siloxan-Zugabe zum Prozessgasgemisch zu einem höheren Anteil an Si-C-Bindungen, wohingegen System II etwas mehr Si-O-Bindungen aufweist.

### Beispiel 49: Chemische Zusammensetzung der Si-DLC Beschichtungen (XPS-Messungen)

Die Schichtsysteme aus dem vorangegangenen Beispiel werden zusätzlich mittels Röntgen-Photoelektronen-Spektroskopie (XPS) untersucht. Diese Methode ist deutlich sensitiver als FTIR und analysiert lediglich die obersten Nanometer (bis zu 10 nm), die unmittelbar mit der zu bindenden Phase in Kontakt steht, keinesfalls aber die komplette Beschichtung. Es ergeben sich dabei folgende Zusammensetzungen:

**Tabelle 7: Chemische Zusammensetzung der Haftvermittleroberflächen**

| **Haftschicht** | **Anteil Si [at%]** | **Anteil C [at%]** | **Anteil O [at%]** | **Anteil sonstige [at%]** |
|---|---|---|---|---|
| I | 0,6 | 90,2 | 9,2 | |
| II | 4,9 | 81,6 | 13,4 | 0,2 |
| VI | 14,8 | 66,8 | 18,3 | 0,2 |
| VII | 6,2 | 79,0 | 14,8 | 0,1 |

### Beispiel 50: Wellendichtring

Ein Radialwellendichtring des Typs BA (Innendurchmesser 72,0 - Außendurchmesser 90,0 - Breite 10,0) wird aus einem Metallring aus Edelstahl sowie FKM II als Elastomerkomponente hergestellt. Die Metallringe werden außer einer Reinigung vor dem Beschichten nicht weiter vorbehandelt und anschließend mit den Schichtsystemen II (HMDSO + Acetylen) und VI (HMDSO + Acetylen) versehen. Anschließend werden sie in ein Formgebungswerkzeug eingelegt. Im Compression Molding Prozess wird dann die Elastomerkomponente mit dem beschichteten Metallring verbunden und das fertige Produkt geformt. Die Haftungsprüfung erfolgt manuell, indem die vulkanisierte Gummikomponente mit einer Zange partiell vom metallischen Grundkörper abgeschält wird. Zur Einteilung des Versagensbilds wird abgeschätzt, zu wieviel Prozent ein Riss im Elastomer erfolgte bzw. wie hoch die Bedeckung der Metalloberfläche ist. Als "i.O." werden Versagensbilder mit mindestens 70 % Elastomerauflage klassifiziert. Metalloberflächen mit weniger Elastomerauflage, d.h. mehr freiliegendem Metall oder Haftvermittler, werden als "n.i.O." beurteilt. Beide Haftvermittlersysteme werden in diesem Test als i.O. beurteilt. Das Versagen erfolgt somit größtenteils im Elastomer, die Haftung vom Elastomer zum metallischen Untergrund ist also größer als die Kohäsion des Gummis. Das Ergebnis zeigt, dass sich die erfindungsgemäßen Verbundmaterialien in hohem Masse zur Herstellung von stabilen Dichtungsartikeln eignen.

## Patentansprüche

1. Verbundmaterial, das ein Substrat und eine Polymerschicht aufweist, die durch eine Haftvermittlerschicht miteinander verbunden sind, wobei die Haftvermittlerschicht durch plasmagestützte chemische Gasphasenabscheidung (PE-CVD) erhältlich ist, bei der zumindest teilweise ein Gemisch von Vorläuferverbindungen eingesetzt wird, das einen ungesättigten Kohlenwasserstoff und eine siliciumorganische Verbindung enthält.

2. Verbundmaterial gemäß Anspruch 1, wobei das Substrat ein Metallsubstrat oder ein Polymersubstrat ist.

3. Verbundmaterial gemäß mindestens einem der vorhergehenden Ansprüche, wobei die siliciumorganische Verbindung ein Siloxan, Silan oder Silikat ist.

4. Verbundmaterial gemäß Anspruch 3, wobei das Siloxan Hexamethyldisiloxan (HMDSO) und/oder das Silan Tetramethylsilan (TMS) ist.

5. Verbundmaterial gemäß mindestens einem der vorhergehenden Ansprüche, wobei der ungesättigte Kohlenwasserstoff Ethylen oder Acetylen ist.

6. Verbundmaterial gemäß mindestens einem der vorhergehenden Ansprüche, wobei die Haftvermittlerschicht als Gradientenschicht ausgebildet ist, wobei in der Gradientenschicht der Anteil an Kohlenstoff zur Polymerschicht hin zunimmt und der Anteil an Si zur Polymerschicht hin abnimmt.

7. Verbundmaterial gemäß mindestens einem der vorhergehenden Ansprüche, wobei die Polymerschicht erhältlich ist, indem eine Polymerverbindung auf die Haftvermittlerschicht aufgetragen und zu der Polymerschicht vernetzt wird, wobei auch die Haftvermittlerschicht mit der Polymerschicht kovalent verbunden wird.

8. Verbundmaterial gemäß mindestens einem der vorhergehenden Ansprüche, wobei die Oberfläche der Haftvermittlerschicht und/oder die Haftvermittlerschicht insgesamt enthält:
| | |
|---|---|
| Si: | 3 at% bis 25 at%, insbesondere 4 at% bis 20 at%, |
| C: | 50 at% bis 90 at%, insbesondere 60 at% bis 85 at%, |
| O: | 5 at% bis 25 at%, insbesondere 10 at% bis 20 at%, |
wobei die Summe aus Si + C + O bevorzugt > 90% ist,
wobei der Rest bevorzugt H, N und gegebenenfalls weitere Elemente aus dem Substrat sind.

9. Verbundmaterial gemäß mindestens einem der vorhergehenden Ansprüche, wobei die Polymerschicht ein Polymer aufweist, das ausgewählt ist aus Fluorkautschuk (FKM), Ethylen-Propylen-Copolymere, wie Ethylen-Propylen-Dien-Kautschuk (EPDM), Polyacrylat-Kautschuk (ACM), Ethylen-Acrylat-Kautschuk (AEM), Butadien-Kautschuk, wie Acrylnitril-butadienkautschuk (NBR), hydrierte Acrylnitril-butadienkautschuk (HNBR), Styrol-Butadien-Kautschuk (SBR), Silikon-Kautschuke, Naturkautschuk (NR), Chloropren-Kautschuk (CR), Epichlorhydrin-Kautschuk (ECO), Polyurethan oder Epoxid-Polymere.

10. Verbundmaterial gemäß mindestens einem der vorhergehenden Ansprüche, wobei das Substrat kein Fluorpolymer ist.

11. Verbundmaterial gemäß mindestens einem der vorhergehenden Ansprüche, beidem das Substrat, die Haftvermittlerschicht und die Polymerschicht nicht mit einem zusätzlichen Bindemittel verbunden sind.

12. Verbundmaterial gemäß mindestens einem der vorhergehenden Ansprüche, wobei die Haftvermittlerschicht eine Dicke von 30 nm bis 10 µm aufweist.

13. Dichtungsartikel, enthaltend ein oder bestehend aus einem Verbundmaterial gemäß mindestens einem der vorhergehenden Ansprüche.

14. Verfahren zur Herstellung eines Verbundmaterials oder eines Dichtungsartikels gemäß mindestens einem der vorhergehenden Ansprüche, umfassend die Schritte:
(a) Bereitstellen des Substrats,
(b) Beschichten des Substrats mit der Haftvermittlerschicht durch plasmagestützte chemische Gasphasenabscheidung (PE-CVD),
(c) Auftragen einer Polymerverbindung auf die Haftvermittlerschicht, und
(d) Vernetzen der Polymerverbindung, wobei auch die Haftvermittlerschicht mit der Polymerschicht kovalent verbunden wird.

15. Verfahren gemäß Anspruch 14, wobei beim Vernetzen der Polymerverbindung in Schritt (d) die ungesättigten Kohlenstoffbindungen an der Oberfläche der Haftvermittlerschicht mit der Polymerverbindung reagieren.

16. Verwendung einer Haftvermittlerschicht zum Verbinden eines Substrats mit einer Polymerschicht, wobei die Haftvermittlerschicht durch plasmagestützte chemische Gasphasenabscheidung (PE-CVD) erhältlich ist, die mit einem Gemisch von Vorläuferverbindungen durchgeführt wird, das mindestens einen ungesättigten Kohlenwasserstoff und mindestens eine siliciumorganische Verbindung enthält.

17. Verwendung eines Verbundmaterials gemäß mindestens einem der vorhergehenden Ansprüche als Dichtungsartikel oder zur Herstellung eines Dichtungsartikels.

## Claims

1. Composite material having a substrate and a polymer layer that are bonded to one another by an adhesion promoter layer, wherein the adhesion promoter layer is obtainable by plasma-enhanced chemical vapour phase deposition (PE-CVD) in which a mixture of precursor compounds comprising an unsaturated hydrocarbon and an organosilicon compound is used at least in part.

2. Composite material according to Claim 1, wherein the substrate is a metal substrate or a polymer substrate.

3. Composite material according to at least one of the preceding claims, wherein the organosilicon compound is a siloxane, silane or silicate.

4. Composite material according to Claim 3, wherein the siloxane is hexamethyldisiloxane (HMDSO) and/or the silane is tetramethylsilane (TMS).

5. Composite material according to at least one of the preceding claims, wherein the unsaturated hydrocarbon is ethylene or acetylene.

6. Composite material according to at least one of the preceding claims, wherein the adhesion promoter layer takes the form of a gradient layer, wherein the proportion of carbon in the gradient layer increases toward the polymer layer and the proportion of Si decreases toward the polymer layer.

7. Composite material according to at least one of the preceding claims, wherein the polymer layer is obtainable by applying a polymer compound to the adhesion promoter layer and crosslinking it to give the polymer layer, wherein the adhesion promoter layer is also covalently bonded to the polymer layer.

8. Composite material according to at least one of the preceding claims, wherein the surface of the adhesion promoter layer and/or the adhesion promoter layer overall contains:
| | |
|---|---|
| Si: | 3 at% to 25 at%, especially 4 at% to 20 at%, |
| C: | 50 at% to 90 at%, especially 60 at% to 85 at%, |
| O: | 5 at% to 25 at%, especially 10 at% to 20 at%, |
| | |
|---|---|
| wherein the sum total of Si + C + O is preferably > 90%, wherein the remainder is preferably H, N and optionally further elements from the substrate. | |

9. Composite material according to at least one of the preceding claims, wherein the polymer layer includes a polymer selected from fluoro rubber (FKM), ethylene-propylene copolymers, such as ethylene-propylene-diene rubber (EPDM), polyacrylate rubber (ACM), ethylene-acrylate rubber (AEM), butadiene rubber, such as acrylonitrile-butadiene rubber (NBR), hydrogenated acrylonitrile-butadiene rubber (HNBR), styrene-butadiene rubber (SBR), silicone rubbers, natural rubber (NR), chloroprene rubber (CR), epichlorohydrin rubber (ECO), polyurethane or epoxy polymers.

10. Composite material according to at least one of the preceding claims, wherein the substrate is not a fluoropolymer.

11. Composite material according to at least one of the preceding claims, in which the substrate, the adhesion promoter layer and the polymer layer are not bonded using an additional binder.

12. Composite material according to at least one of the preceding claims, wherein the adhesion promoter layer has a thickness of 30 nm to 10 µm.

13. Sealing article comprising or consisting of a composite material according to at least one of the preceding claims.

14. Process for producing a composite material or a sealing article according to at least one of the preceding claims, comprising the steps of:
(a) providing the substrate,
(b) coating the substrate with the adhesion promoter layer by plasma-enhanced chemical vapour phase deposition (PE-CVD),
(c) applying a polymer compound to the adhesion promoter layer, and
(d) crosslinking the polymer compound, wherein the adhesion promoter layer is also covalently bonded to the polymer layer.

15. Process according to Claim 14, wherein the crosslinking of the polymer compound in step (d) comprises reaction of the unsaturated carbon bonds at the surface of the adhesion promoter layer with the polymer compound.

16. Use of an adhesion promoter layer for bonding of a substrate to a polymer layer, wherein the adhesion promoter layer is obtainable by plasma-enhanced chemical vapour phase deposition (PE-CVD) which is performed with a mixture of precursor compounds comprising at least one unsaturated hydrocarbon and at least one organosilicon compound.

17. Use of a composite material according to at least one of the preceding claims as sealing article or for production of a sealing article.

## Revendications

1. Matériau composite qui présente un substrat et une couche de polymère qui sont reliés ensemble par une couche favorisant l'adhérence, la couche favorisant l'adhérence étant obtenue par dépôt chimique en phase gazeuse supporté par plasma (PE-CVD), dans lequel un mélange de composés précurseurs est utilisé au moins partiellement, qui contient un hydrocarbure insaturé et un composé organosilicié.

2. Matériau composite selon la revendication 1, le substrat étant un substrat métallique ou un substrat de polymère.

3. Matériau composite selon au moins l'une des revendications précédentes, le composé organosilicié étant un siloxane, un silane ou un silicate.

4. Matériau composite selon la revendication 3, le siloxane étant l'hexaméthyldisiloxane (HMDSO) et/ou le silane étant le tétraméthylsilane (TMS).

5. Matériau composite selon au moins l'une des revendications précédentes, l'hydrocarbure insaturé étant l'éthylène ou l'acétylène.

6. Matériau composite selon au moins l'une des revendications précédentes, la couche favorisant l'adhérence étant réalisée comme couche à gradient, dans lequel dans la couche à gradient la proportion de carbone augmente vers la couche de polymère et la proportion de Si diminue vers la couche de polymère.

7. Matériau composite selon au moins l'une des revendications précédentes, la couche de polymère pouvant être obtenue par application d'un composé polymérique sur la couche favorisant l'adhérence et par réticulation de celui-ci à la couche de polymère, la couche favorisant l'adhérence étant également reliée de manière covalente à la couche de polymère.

8. Matériau composite selon au moins l'une des revendications précédentes, la surface de la couche favorisant l'adhérence et/ou la totalité de la couche favorisant l'adhérence contenant :
Si : 3 at % à 25 at %, en particulier 4 at % à 20 at %,
C : 50 at % à 90 at %, en particulier 60 at % à 85 at %,
O : 5 at % à 25 at %, en particulier 10 at % à 20 at %,
la somme de Si + C + O étant préférablement > 90 %,
le reste étant préférablement H, N et éventuellement d'autres éléments du substrat.

9. Matériau composite selon au moins l'une des revendications précédentes, la couche de polymère présentant un polymère qui est choisi parmi un caoutchouc fluoré (FKM), des copolymères d'éthylène-propylène, comme un caoutchouc d'éthylène-propylène-diène (EPDM), un caoutchouc de polyacrylate (ACM), un caoutchouc d'éthylèneacrylate (AEM), un caoutchouc de butadiène, comme un caoutchouc d'acrylonitrile-butadiène (NBR), un caoutchouc d'acrylonitrile-butadiène hydrogéné (HNBR), un caoutchouc de styrène-butadiène (SBR), des caoutchoucs de silicone, un caoutchouc naturel (NR), un caoutchouc de chloroprène (CR), un caoutchouc d'épichlorhydrine (ECO), un polyuréthane ou des polymères d'époxyde.

10. Matériau composite selon au moins l'une des revendications précédentes, le substrat n'étant pas un fluoropolymère.

11. Matériau composite selon au moins l'une des revendications précédentes, dans lequel le substrat, la couche favorisant l'adhérence et la couche de polymère ne sont pas reliés ensemble par un liant supplémentaire.

12. Matériau composite selon au moins l'une des revendications précédentes, la couche favorisant l'adhérence présentant une épaisseur de 30 nm à 10 µm.

13. Article d'étanchéité contenant ou constitué d'un matériau composite selon au moins l'une des revendications précédentes.

14. Procédé pour la fabrication d'un matériau composite ou d'un article d'étanchéité selon au moins l'une des revendications précédentes, comprenant les étapes :
(a) mise à disposition du substrat,
(b) revêtement du substrat avec la couche favorisant l'adhérence par dépôt chimique en phase gazeuse supporté par plasma (PE-CVD),
(c) application d'un composé polymérique sur la couche favorisant l'adhérence, et
(d) réticulation du composé polymérique, la couche favorisant l'adhérence étant également reliée de manière covalente à la couche de polymère.

15. Procédé selon la revendication 14, dans lequel lors de la réticulation du composé polymérique dans l'étape (d), les liaisons carbonées insaturées au niveau de la surface de la couche favorisant l'adhérence réagissent avec le composé polymérique.

16. Utilisation d'une couche favorisant l'adhérence pour la liaison d'un substrat avec une couche de polymère, la couche favorisant l'adhérence étant obtenue par dépôt chimique en phase gazeuse supporté par plasma (PE-CVD) qui est réalisé avec un mélange de composés précurseurs qui contient au moins un hydrocarbure insaturé et au moins un composé organosilicié.

17. Utilisation d'un matériau composite selon au moins l'une des revendications précédentes en tant qu'article d'étanchéité ou pour la fabrication d'un article d'étanchéité.
